# EUROPÄISCHE PATENTSCHRIFT

(11) **EP 2 820 108 B1**
(45) Veröffentlichungstag und Bekanntmachung des Hinweises auf die Patenterteilung: **28.08.2019**
(21) Anmeldenummer: 13705164.5
(22) Anmeldetag: 19.02.2013
(51) Int. Cl.: C09K 11/56, C09K 11/70, C09K 11/88

(54) **LUMINESZIERENDE, CADMIUMFREIE KERN-MULTISCHALEN-QUANTENPUNKTE AUF BASIS VON INDIUMPHOSPHID**
LUMINESCENT, CADMIUM-FREE CORE/MULTI-SHELL QUANTUM DOTS ON THE BASIS OF INDIUM PHOSPHIDE
BOÎTES QUANTIQUES COEUR-MULTICOQUE EXEMPTES DE CADMIUM ET LUMINESCENTES À BASE DE PHOPHURE D'INDIUM

(30) Priorität: 28.02.2012 DE 102012203036
(43) Veröffentlichungstag der Anmeldung: 07.01.2015
(73) Patentinhaber: Fraunhofer Gesellschaft zur Förderung der angewandten Forschung e.V., 80686 München (DE); Korea Electronics Technology Institute, Gyeonggi-do 463-816 (KR)
(72) Erfinder: GRECO, Tonino, 10437 Berlin (DE); IPPEN, Christian, 14471 Potsdam (DE); WEDEL, Armin, 14513 Teltow (DE)
(74) Vertreter: Maiwald Patent- und Rechtsanwaltsgesellschaft mbH
(86) Internationale Anmeldenummer: PCT/EP2013/053264
(87) Internationale Veröffentlichungsnummer: WO 2013/127662

(56) Entgegenhaltungen:
- WO-A1-2010/015824
- WO-A1-2010/089545
- CN-A- 101 113 335
- KR-A- 20050 074 779
- KR-A- 20110 091 361

## Beschreibung

Die vorliegende Erfindung betrifft cadmiumfreie Kern-Multischalen-Quantenpunkte, ein Verfahren zur Herstellung solcher cadmiumfreien Kern-Multischalen-Quantenpunkte, deren Verwendung und optoelektronische Bauelemente, die cadmiumfreie Kern-Multischalen-Quantenpunkte aufweisen.

Kolloidale Halbleiter-Nanopartikel, auch Quantenpunkte genannt, sind aufgrund ihrer optischen Eigenschaften insbesondere von Interesse für die Anwendung in optoelektronischen Bauelementen. Zu den vorteilhaften Eigenschaften solcher kolloidalen Quantenpunkte zählen u.a. gute Lumineszenzeffizienzen, gute Einstellbarkeit der Emissionswellenlänge über die Partikelgröße sowie insbesondere die geringe Breite des Emissionspeaks, die in einer hohen Farbsättigung resultiert. Darüber hinaus sind kolloidale Quantenpunkte in organischen Lösungsmitteln löslich, was den Einsatz von günstigen und schnellen lösungsbasierten Prozessierungsmethoden ermöglicht.

Häufig werden Quantenpunkte aus II-IV-Halbleitern, vornehmlich auf Basis von Cadmiumverbindungen wie CdSe, CdS oder CdTe, synthetisiert. Zur Verbesserung der Lumineszenzquantenausbeute dieser Verbindungen wird die Partikeloberfläche häufig mit einem weiteren Halbleitermaterial epitaktisch beschichtet. Weist dieses Schalenmaterial eine breitere Bandlücke auf, wird die Interaktion des Excitons mit Defektzuständen an der Partikeloberfläche reduziert, was die Wahrscheinlichkeit der strahlenden Rekombination erhöht. Populär ist der Einsatz von ZnS als Schale, da dieses eine breite Bandlücke und eine kompatible Gitterstruktur zu CdSe aufweist.

Voraussetzung für die epitaktische Beschichtung ist eine möglichst ähnliche Gitterkonstante von Kern- und Schalenmaterial. Für CdSe und ZnS beträgt der Gitterkonstanten-Unterschied 12%. Dieser Unterschied ist gerade klein genug für die erfolgreiche Beschichtung mit bis zu zwei Monolagen ZnS, bei höheren Schalen-Schichtdicken erzeugt die Spannung an der Kern-Schale-Grenzfläche neue Defekte, sodass die Quantenausbeute wieder reduziert wird.

Für CdSe werden insbesondere Mehrfachschalen-Systeme wie zum Beispiel CdSe/CdS/ZnS oder CdSe/ZnSe/ZnS vorgeschlagen und realisiert, bei denen die erste Schale eine Gitterkonstante zwischen denen von Kern und äußerer Schale aufweist, sodass der Gitterkonstanten-Unterschied abgestuft vermittelt wird und daher weniger Verspannungen an den Grenzflächen auftreten.

Cadmiumverbindungen weisen jedoch eine hohe Toxizität auf. Darüber hinaus bestehen zwischenzeitlich entsprechende umweltpolitische Regulierungen (z.B. RoHS-Direktive), wodurch die Aussichten für den realen Einsatz dieser Quantenpunkte in beispielsweise optoelektronischen Bauelementen gering sind. Zusätzlich sind die Verfahren zur Herstellung von Quantenpunkten mit epitaktischer Beschichtung meist sehr aufwändig. Insbesondere verlaufen diese Verfahren über mehrere Synthesestufen, die zeitaufwändige Reinigungsprozesse der jeweiligen Zwischenprodukte erforderlich machen. Der Aufwand bei der Aufarbeitung des jeweiligen Reaktionsgemisches resultiert zusätzlich in einem hohen kostenintensiven Verbrauch von Chemikalien und Lösungsmitteln.

In KR 2001/0091361 A1 wird ein Verfahren zur Herstellung eines Indiumphosphid Quantenpunkts mit einer Gruppe II bis VI Element Schale offenbart.

Daher besteht nach wie vor ein Bedarf an Quantenpunkten, die sowohl cadmiumfrei sind als auch eine ausreichende Lumineszenzquantenausbeute aufweisen. Ferner sollen diese Quantenpunkte auf einfache Weise herstellbar sein.

Demnach ist es Aufgabe der vorliegenden Erfindung Quantenpunkt-Strukturen bereitzustellen, der die Vorteile von bekannten Quantenpunkten vereint und deren Nachteile vermeidet. Es ist insbesondere Aufgabe der vorliegenden Erfindung die Vorteile von cadmiumhaltigen Quantenpunkten zu erhalten, d.h. eine gute Lumineszenzquantenausbeute, resultierend aus einer möglichst ähnlichen Gitterkonstante von Kern- und Schalenmaterial. Eine weitere Aufgabe besteht darin, dass die Quantenpunkte cadmiumfrei sind. Eine zusätzliche Aufgabe besteht darin, dass die Quantenpunkte durch ein einfaches Verfahren bereit gestellt werden können. Insbesondere besteht eine Aufgabe darin, dass das Verfahren ohne Reinigungsprozesse nach den jeweiligen Zwischenschritten durchgeführt werden kann.

Die Lösung der genannten und weiterer Aufgaben ergibt sich aus den Gegenständen der unabhängigen Ansprüche. Vorteilhafte Ausführungsformen ergeben sich durch deren Kombination mit den Merkmalen der abhängigen Ansprüche.

Gemäß einem Aspekt der vorliegenden Erfindung wird ein cadmiumfreier Kern-Multischalen-Quantenpunkt bereitgestellt, umfassend
a) einen Kern umfassend Indiumphosphid,
b) eine über der Oberfläche des Kerns aufgewachsene erste Schale aus einem ersten Material umfassend Zinkselenid, und
c) eine über der Oberfläche der ersten Schale aufgewachsene zweite Schale aus einem zweiten Material, das ungleich dem ersten Material der ersten Schale ist,
wobei der Gitterkonstanten-Unterschied zwischen dem Kern und der zweiten Schale weniger als 13 % beträgt.

Gemäß einem weiteren Aspekt der vorliegenden Erfindung wird ein Verfahren zur Herstellung von cadmiumfreien Kern-Multischalen-Quantenpunkten gemäß der vorliegenden Erfindung bereitgestellt, das Verfahren umfassend:
a) Bereitstellen einer Rohlösung umfassend Indiumphosphid-Nanopartikel,
b) Bereitstellen mindestens eines Zinkcarboxylats,
c) Bereitstellen mindestens einer Schwefel- oder Selenquelle,
d) Inkontaktbringen der Rohlösung umfassend Indiumphosphid-Nanopartikel aus Schritt a) mit mindestens einem Zinkcarboxylat aus Schritt b),
e) Inkontaktbringen der aus Schritt d) erhaltenen Mischung mit mindestens einer Schwefel- oder Selenquelle aus Schritt c), wobei im Schritt e) mindestens eine Selenquelle oder mindestens eine Schwefelquelle und eine Selenquelle verwendet wird,
f) Inkontaktbringen der aus Schritt e) erhaltenen Mischung mit mindestens einem Zinkcarboxylat aus Schritt b), und
g) Inkontaktbringen der aus Schritt f) erhaltenen Mischung mit mindestens einer Schwefel- oder Selenquelle aus Schritt c), wobei im Schritt g) mindestens eine Schwefelquelle oder mindestens eine Schwefelquelle und eine Selenquelle verwendet wird,
wobei die cadmiumfreien Kern-Multischalen-Quantenpunkte in einem Ein-Topf-Verfahren hergestellt werden

Gemäß einem weiteren Aspekt der vorliegenden Erfindung wird die Verwendung eines cadmiumfreien Kern-Multischalen-Quantenpunktes gemäß der vorliegenden Erfindung für den Einsatz in OLEDs, Solarzellen, Beleuchtungsmitteln, Röntgenstrahl-Szintillatoren, Fluoreszenzkollektoren, organischen Feldeffekttransistoren, als Fluoreszenzmarker in der Bioanalytik oder als lumineszierendes Sicherheitsmerkmal bereitgestellt.

Gemäß einem weiteren Aspekt der vorliegenden Erfindung wird ein optoelektronisches Bauelement bereitgestellt, aufweisend mindestens einen cadmiumfreien Kern-Multischalen-Quantenpunkt gemäß der vorliegenden Erfindung.

Der erfindungsgemäße Quantenpunkt ist cadmiumfrei und weist eine gute Lumineszenzquantenausbeute, resultierend aus einer möglichst ähnlichen Gitterkonstante von Kern- und Schalenmaterial, auf. Des Weiteren können die Quantenpunkte ohne Reinigungsprozesse nach den jeweiligen Zwischenschritten hergestellt werden, so dass auf eine kosten- und zeitintensive Herstellung der Quantenpunkte verzichtet werden kann.

Im Rahmen der vorliegenden Erfindung wird der Begriff "Kern-Multischalen-Quantenpunkt" in seiner üblichen, dem Fachmann geläufigen Bedeutung verstanden und bezieht sich auf einen Kern aus Halbleiter-Nanopartikel auf die mehrere Schalen epitaktisch aufgeschichtet werden.

Optional kann auf die Oberfläche der zweiten Schale des erfindungsgemäßen cadmiumfreien Kern-Multischalen-Quantenpunktes mindestens eine weitere Schale umfassend ein weiteres Material aufgewachsen werden.

Die Größe der cadmiumfreien Kern-Multischalen-Quantenpunkte kann über einen breiten Bereich variieren. Als geeignete durchschnittliche Partikelgröße kann in diesem Zusammenhang z.B. ein Bereich von 1 bis 15 nm genannt werden. Insbesondere bevorzugt beträgt die durchschnittliche Partikelgröße der cadmiumfreien Kern-Multischalen-Quantenpunkt zwischen 1 und 10 nm oder zwischen 2 und 7 nm. Beispielsweise beträgt die durchschnittliche Partikelgröße der cadmiumfreien Kern-Multischalen-Quantenpunkte zwischen 3,5 und 4,5 nm. Die Bestimmung der durchschnittlichen Partikelgröße erfolgt bevorzugt über Elektronenmikroskopie.

Ebenso kann auch die Größe des Kerns der cadmiumfreien Kern-Multischalen-Quantenpunkte kann über einen breiten Bereich variieren. Vorzugsweise kann die durchschnittliche Größe des Kerns in einem Bereich von 0,5 bis 10 nm oder in einem Bereich von 2 bis 10 nm liegen. Beispielsweise kann die durchschnittliche Größe des Kerns in einem Bereich von 2 bis 5 nm liegen.

Auch die Schichtdicke der ersten, zweiten und optional jeder weiteren Schale der cadmiumfreien Kern-Multischalen-Quantenpunkte kann über einen breiten Bereich variieren. Vorzugsweise kann die durchschnittliche Schichtdicke der ersten Schale von 0,2 bis 1 nm oder von 0,2 bis 0,7 nm betragen. Unabhängig von der Schichtdick der ersten Schale kann die Schichtdicke der zweiten Schale von 0,2 bis 1 nm oder von 0,2 bis 0,7 nm betragen.

Ferner weisen die erfindungsgemäßen cadmiumfreien Kern-Multischalen-Quantenpunkte vorzugsweise eine sphärische Partikelform auf.

In einer bevorzugten Ausführungsform der vorliegenden Erfindung weisen die cadmiumfreien Kern-Multischalen-Quantenpunkte eine Größenverteilung von weniger als 13 % auf, bevorzugt weniger als 12 % und weiter bevorzugt weniger als 11 %. Beispielsweise weisen die cadmiumfreien Kern-Multischalen-Quantenpunkte eine Größendispersion zwischen 5 und 13 % auf, bevorzugt zwischen 7 und 12 % und weiter bevorzugt zwischen 9 und 11 %.

Mit den erfindungsgemäßen cadmiumfreien Kern-Multischalen-Quantenpunkten können Quantenausbeuten von mindestens 50 % erzielt werden. Beispielsweise können mit den erfindungsgemäßen cadmiumfreien Kern-Multischalen-Quantenpunkten Quantenausbeuten in einem Bereich von 50 bis 75 % und bevorzugt in einem Bereich von 50 bis 65 % erzielt werden.

In einer bevorzugten Ausführungsform der vorliegenden Erfindung können die cadmiumfreien Kern-Multischalen-Quantenpunkte eine Emissionswellenlänge in einem Bereich von 400 bis 800 nm aufweisen. Insbesondere können die cadmiumfreien Kern-Multischalen-Quantenpunkte eine Emissionswellenlänge in einem Bereich von 470 bis 650 nm aufweisen. Beispielsweise können die cadmiumfreien Kern-Multischalen-Quantenpunkte eine Emissionswellenlänge von 540 bis 580 nm aufweisen.

Erfindungsgemäß umfasst der Kern der cadmiumfreien Kern-Multischalen-Quantenpunkte Indiumphosphid. In einer bevorzugten Ausführungsform der vorliegenden Erfindung besteht der Kern aus Indiumphosphid.

Vorzugsweise umfasst der Kern Indiumphosphid in einer Menge von 50 bis 100 Gew.-% oder 60 bis 99 Gew.-%, bezogen auf die Gesamtmasse des Kerns. Alternativ umfasst der Kern Indiumphosphid in einer Menge von beispielsweise 75 bis 98 Gew.-% oder 80 bis 97 Gew.-%, bezogen auf die Gesamtmasse des Kerns. Vorzugsweise umfasst der Kern Indiumphosphid in einer Menge von beispielsweise 82 bis 95 Gew.-%, bezogen auf die Gesamtmasse des Kerns.

In einer bevorzugten Ausführungsform der vorliegenden Erfindung ist der Kern der cadmiumfreien Kern-Multischalen-Quantenpunkte ein Mischnanopartikel umfassend Indiumphosphid und ein Material, das identisch ist mit dem ersten Material der ersten Schale oder mit dem zweiten Material der zweiten Schale.

Der Kern umfasst daher vorzugsweise Indiumphosphid und Zinksulfid und/oder Zinkselenid. Beispielsweise umfasst der Kern Indiumphosphid, Zinksulfid und Zinkselenid. Alternativ umfasst der Kern Indiumphosphid und Zinksulfid oder Zinkselenid.

In einer bevorzugten Ausführungsform der vorliegenden Erfindung umfasst der Kern Indiumphosphid und Zinksulfid. In einer weiteren bevorzugten Ausführungsform der vorliegenden Erfindung umfasst der Kern Indiumphosphid und Zinkselenid.

Beispielsweise umfasst der Kern Zinksulfid und/oder Zinkselenid in einer Menge von 2 bis 25 Gew.-% oder 3 bis 20 Gew.-%, bezogen auf die Gesamtmasse des Kerns. Vorzugsweise umfasst der Kern Zinksulfid und/oder Zinkselenid in einer Menge von 5 bis 18 Gew.-%, bezogen auf die Gesamtmasse des Kerns.

In einer bevorzugten Ausführungsform der vorliegenden Erfindung umfasst der Kern Indiumphosphid in einer Menge von 75 bis 98 Gew.-%, bezogen auf die Gesamtmasse des Kerns, und Zinksulfid und/oder Zinkselenid in einer Menge von 2 bis 25 Gew.-%, bezogen auf die Gesamtmasse des Kerns. Vorzugsweise umfasst der Kern Indiumphosphid in einer Menge von 80 bis 97 Gew.-%, bezogen auf die Gesamtmasse des Kerns, und Zinksulfid und/oder Zinkselenid in einer Menge von 3 bis 20 Gew.-%, bezogen auf die Gesamtmasse des Kerns. Alternativ umfasst der Kern Indiumphosphid in einer Menge von beispielsweise 82 bis 95 Gew.-%, bezogen auf die Gesamtmasse des Kerns, und Zinksulfid und/oder Zinkselenid in einer Menge von 5 bis 18 Gew.-%, bezogen auf die Gesamtmasse des Kerns.

In einer bevorzugten Ausführungsform der vorliegenden Erfindung umfasst der Kern Indiumphosphid in einer Menge von 75 bis 98 Gew.-%, bezogen auf die Gesamtmasse des Kerns, und Zinksulfid oder Zinkselenid in einer Menge von 2 bis 25 Gew.-%, bezogen auf die Gesamtmasse des Kerns. Vorzugsweise umfasst der Kern Indiumphosphid in einer Menge von 80 bis 97 Gew.-%, bezogen auf die Gesamtmasse des Kerns, und Zinksulfid oder Zinkselenid in einer Menge von 3 bis 20 Gew.-%, bezogen auf die Gesamtmasse des Kerns. Alternativ umfasst der Kern Indiumphosphid in einer Menge von beispielsweise 82 bis 95 Gew.-%, bezogen auf die Gesamtmasse des Kerns, und Zinksulfid oder Zinkselenid in einer Menge von 5 bis 18 Gew.-%, bezogen auf die Gesamtmasse des Kerns.

Beispielsweise umfasst der Kern Indiumphosphid in einer Menge von 75 bis 98 Gew.-%, bezogen auf die Gesamtmasse des Kerns, und Zinksulfid in einer Menge von 2 bis 25 Gew.-%, bezogen auf die Gesamtmasse des Kerns. Vorzugsweise umfasst der Kern Indiumphosphid in einer Menge von 80 bis 97 Gew.-%, bezogen auf die Gesamtmasse des Kerns, und Zinksulfid in einer Menge von 3 bis 20 Gew.-%, bezogen auf die Gesamtmasse des Kerns.

In einer bevorzugten Ausführungsform der vorliegenden Erfindung umfasst der Kern Indiumphosphid in einer Menge von 82 bis 95 Gew.-%, bezogen auf die Gesamtmasse des Kerns, und Zinksulfid in einer Menge von 5 bis 18 Gew.-%, bezogen auf die Gesamtmasse des Kerns.

Alternativ umfasst der Kern Indiumphosphid in einer Menge von 75 bis 98 Gew.-%, bezogen auf die Gesamtmasse des Kerns, und Zinkselenid in einer Menge von 2 bis 25 Gew.-%, bezogen auf die Gesamtmasse des Kerns. Vorzugsweise umfasst der Kern Indiumphosphid in einer Menge von 80 bis 97 Gew.-%, bezogen auf die Gesamtmasse des Kerns, und Zinkselenid in einer Menge von 3 bis 20 Gew.-%, bezogen auf die Gesamtmasse des Kerns.

In einer bevorzugten Ausführungsform der vorliegenden Erfindung umfasst der Kern Indiumphosphid in einer Menge von 82 bis 95 Gew.-%, bezogen auf die Gesamtmasse des Kerns, und Zinkselenid in einer Menge von 5 bis 18 Gew.-%, bezogen auf die Gesamtmasse des Kerns.

Erfindungsgemäß umfasst der cadmiumfreie Kern-Multischalen-Quantenpunkt eine erste Schale aus einem ersten Material, die über der Oberfläche des Indiumphosphid-Kerns aufgewachsen ist.

Das erste Material der ersten Schale wird vorzugsweise aus einem Material ausgewählt, das eine breite Bandlücke und eine Gitterstruktur aufweist, die kompatibel zu der Gitterstruktur des Indiumphosphid-Kerns ist. Vorzugsweise weist das erste Material der ersten Schale eine Bandlücke in einem Bereich von 2,5 bis 4 eV und weiter bevorzugt in einem Bereich von 2,7 bis 3,7 eV auf. Ferner sollte das erste Material der ersten Schale vorzugsweise aus einem Material ausgewählt werden, das eine Gitterstruktur aufweist, die kompatibel zu der Gitterstruktur der zweiten Schale ist.

Vorzugsweise wird das erste Material der ersten Schale so ausgewählt, dass die erste Schale eine Gitterkonstante aufweist, die zwischen der von Kern und zweiter Schale liegt.

Das erste Material der ersten Schale kann beispielsweise so ausgewählt werden, dass der Gitterkonstanten-Unterschied zwischen dem Kern und der ersten Schale zwischen 2 % und 8 % und bevorzugt zwischen 2 % und 6 % beträgt. Insbesondere beträgt der Gitterkonstanten-Unterschied zwischen dem Kern und der ersten Schale zwischen 3 % und 5 %.

In einer weiteren Ausführungsform der vorliegenden Erfindung beträgt der Gitterkonstanten-Unterschied zwischen der ersten Schale und der zweiten Schale zwischen 3 % und 9 % und bevorzugt zwischen 3 % und 7 %. Insbesondere beträgt der Gitterkonstanten-Unterschied zwischen der ersten Schale und der zweiten Schale zwischen 4 % und 6 %.

Beispielsweise beträgt der Gitterkonstanten-Unterschied zwischen dem Kern und der ersten Schale zwischen 2 % und 8 % und der Gitterkonstanten-Unterschied zwischen der ersten Schale und der zweiten Schale beträgt zwischen 3 % und 9 %. Vorzugsweise beträgt der Gitterkonstanten-Unterschied zwischen dem Kern und der ersten Schale zwischen 2 % und 6 % und der Gitterkonstanten-Unterschied zwischen der ersten Schale und der zweiten Schale beträgt zwischen 3 % und 7 %. Insbesondere beträgt der Gitterkonstanten-Unterschied zwischen dem Kern und der ersten Schale zwischen 3 % und 5 % und der Gitterkonstanten-Unterschied zwischen der ersten Schale und der zweiten Schale beträgt zwischen 4 % und 6 %. Beispielsweise beträgt der Gitterkonstanten-Unterschied zwischen dem Kern und der ersten Schale etwa 4 % und der Gitterkonstanten-Unterschied zwischen der ersten Schale und der zweiten Schale beträgt etwa 5 %.

Das erste Material der ersten Schale ist bevorzugt ausgewählt aus der Gruppe umfassend Zinkselenid, Zinksulfid oder deren Gemische.

Beispielsweise umfasst das erste Material der ersten Schale Zinkselenid oder Zinksulfid. Insbesondere umfasst das erste Material der ersten Schale Zinkselenid. In einer weiteren Ausführungsform umfasst das erste Material der ersten Schale eine Mischung aus Zinkselenid und Zinksulfid.

Vorzugsweise umfasst die erste Schale Zinkselenid und/oder Zinksulfid als erstes Material in einer Menge von beispielsweise 50 bis 100 Gew.-% oder 60 bis 99 Gew.-%, bezogen auf die Gesamtmasse der ersten Schale. Alternativ umfasst die erste Schale Zinkselenid und/oder Zinksulfid als erstes Material in einer Menge von beispielsweise 75 bis 98 Gew.-% oder 80 bis 97 Gew.-%, bezogen auf die Gesamtmasse der ersten Schale.

Umfasst das erste Material der ersten Schale Zinkselenid und Zinksulfid, kann das Gewichtsverhältnis von Zinkselenid zu Zinksulfid über einen breiten Bereich variieren. Vorzugsweise liegt das Gewichtsverhältnis von Zinkselenid zu Zinksulfid in der ersten Schale in einem Bereich zwischen 99/1 und 1/99, weiter bevorzugt in einem Bereich zwischen 90/10 und 10/90.

Das Gewichtsverhältnis von erster Schale zu Kern kann über einen breiten Bereich variieren und liegt bevorzugt in einem Bereich zwischen 80/20 und 20/80, weiter bevorzugt in einem Bereich zwischen 70/30 und 30/70.

Erfindungsgemäß umfasst der cadmiumfreie Kern-Multischalen-Quantenpunkt eine zweite Schale aus einem zweiten Material, die über der Oberfläche der ersten Schale aufgewachsen ist. Ferner ist erforderlich, dass das zweite Material der zweiten Schale ungleich dem Material der ersten Schale ist.

Der Begriff "ungleich" wird im Rahmen der vorliegenden Erfindung in seiner üblichen, dem Fachmann geläufigen Bedeutung verstanden und schließt lediglich aus, dass das zweite Material der zweiten Schale identisch ist mit dem ersten Material der ersten Schale, d.h. eine Identität der Schalenzusammensetzung zwischen erster und zweiter Schale von mehr als 99 % ist ausgeschlossen. Insbesondere schließt dieser Begriff nicht aus, dass das zweite Material der zweiten Schale das erste Material der ersten Schale in einem Gemisch mit einem weiteren Material umfasst und umgekehrt.

Das zweite Material der zweiten Schale wird vorzugsweise aus einem Material ausgewählt, das eine Gitterstruktur aufweist, die kompatibel zu der Gitterstruktur der ersten Schale ist. Ferner ist erforderlich, dass das zweite Material der zweiten Schale aus einem Material ausgewählt wird, so dass der Gitterkonstanten-Unterschied zwischen dem Kern und der zweiten Schale weniger als 13 % beträgt.

Vorzugsweise wird das zweite Material der zweiten Schale so ausgewählt, dass der Gitterkonstanten-Unterschied zwischen dem Kern und der zweiten Schale weniger als 12 % und insbesondere weniger als 11 % beträgt. Beispielsweise beträgt der Gitterkonstanten-Unterschied zwischen dem Kern und der zweiten Schale weniger als 10 %.

In einer bevorzugten Ausführungsform der vorliegenden Erfindung beträgt der Gitterkonstanten-Unterschied zwischen dem Kern und der zweiten Schale zwischen 5 % und 13 %, bevorzugt zwischen 5 % und 12 %, weiter bevorzugt zwischen 5 % und 11 % und noch weiter bevorzugt zwischen 5 % und 10 %. Insbesondere beträgt der Gitterkonstanten-Unterschied zwischen dem Kern und der zweiten Schale zwischen 7 % und 10 % oder zwischen 8 % und 10 %.

Das zweite Material der zweiten Schale ist bevorzugt ausgewählt aus der Gruppe umfassend Zinkselenid, Zinksulfid oder deren Gemische.

Beispielsweise umfasst das zweite Material der zweiten Schale Zinkselenid oder Zinksulfid. Insbesondere umfasst das zweite Material der zweiten Schale Zinksulfid. In einer weiteren Ausführungsform umfasst das zweite Material der zweiten Schale eine Mischung aus Zinkselenid und Zinksulfid.

Vorzugsweise umfasst die zweite Schale Zinkselenid und/oder Zinksulfid als zweites Material in einer Menge von beispielsweise 50 bis 100 Gew.-% oder 60 bis 99 Gew.-%, bezogen auf die Gesamtmasse der zweiten Schale. Alternativ umfasst die zweite Schale Zinkselenid und/oder Zinksulfid als zweites Material in einer Menge von beispielsweise 75 bis 98 Gew.-% oder 80 bis 97 Gew.-%, bezogen auf die Gesamtmasse der zweiten Schale.

Umfasst das zweite Material der zweiten Schale Zinkselenid und Zinksulfid, kann das Gewichtsverhältnis von Zinkselenid zu Zinksulfid über einen breiten Bereich variieren. Vorzugsweise liegt das Gewichtsverhältnis von Zinkselenid zu Zinksulfid in der zweiten Schale in einem Bereich zwischen 99/1 und 1/99, weiter bevorzugt in einem Bereich zwischen 90/10 und 10/90.

Das Gewichtsverhältnis von erster Schale zu zweiter Schale kann über einen breiten Bereich variieren und liegt bevorzugt in einem Bereich zwischen 80/20 und 20/80, weiter bevorzugt in einem Bereich zwischen 70/30 und 30/70 und noch weiter bevorzugt in einem Bereich zwischen 60/40 und 40/60.

Auch das Gewichtsverhältnis von zweiter Schale zu Kern kann über einen breiten Bereich variieren und liegt bevorzugt in einem Bereich zwischen 80/20 und 20/80, weiter bevorzugt in einem Bereich zwischen 70/30 und 30/70 und noch weiter bevorzugt in einem Bereich zwischen 60/40 und 40/60.

In einer bevorzugten Ausführungsform der vorliegenden Erfindung umfasst der erfindungsgemäße cadmiumfreie Kern-Multischalen-Quantenpunkt einen Kern umfassend Indiumphosphid, vorzugsweise einen Kern umfassend Indiumphosphid und Zinkselenid oder Zinksulfid, eine über der Oberfläche des Kerns aufgewachsene erste Schale umfassend Zinkselenid und eine über der Oberfläche der ersten Schale aufgewachsene zweite Schale umfassend Zinksulfid. Vorzugsweise umfasst der erfindungsgemäße cadmiumfreie Kern-Multischalen-Quantenpunkt einen Kern umfassend Indiumphosphid, vorzugsweise einen Kern umfassend Indiumphosphid und Zinksulfid, eine über der Oberfläche des Kerns aufgewachsene erste Schale umfassend Zinkselenid und eine über der Oberfläche der ersten Schale aufgewachsene zweite Schale umfassend Zinksulfid. Beispielsweise umfasst der erfindungsgemäße cadmiumfreie Kern-Multischalen-Quantenpunkt einen Kern umfassend Indiumphosphid und Zinksulfid, vorzugsweise bestehend aus Indiumphosphid und Zinksulfid, eine über der Oberfläche des Kerns aufgewachsene erste Schale umfassend Zinkselenid und eine über der Oberfläche der ersten Schale aufgewachsene zweite Schale umfassend Zinksulfid.

Alternativ umfasst der erfindungsgemäße cadmiumfreie Kern-Multischalen-Quantenpunkt einen Kern umfassend Indiumphosphid, vorzugsweise einen Kern umfassend Indiumphosphid und Zinksulfid, eine über der Oberfläche des Kerns aufgewachsene erste Schale umfassend Zinksulfid und eine über der Oberfläche der ersten Schale aufgewachsene zweite Schale umfassend Zinkselenid.

In einer weiteren Ausführungsform der vorliegenden Erfindung umfasst der erfindungsgemäße cadmiumfreie Kern-Multischalen-Quantenpunkt einen Kern umfassend Indiumphosphid, vorzugsweise einen Kern umfassend Indiumphosphid und Zinksulfid oder Zinkselenid, eine über der Oberfläche des Kerns aufgewachsene erste Schale umfassend Zinkselenid oder Zinksulfid, vorzugsweise Zinkselenid, und eine über der Oberfläche der ersten Schale aufgewachsene zweite Schale umfassend Zinkselenid und Zinksulfid. Umfasst das zweite Material der zweiten Schale Zinkselenid und Zinksulfid, liegt das Gewichtsverhältnis von Zinkselenid zu Zinksulfid in der zweiten Schale vorzugsweise in einem Bereich zwischen 99/1 und 1/99, weiter bevorzugt in einem Bereich zwischen 90/10 und 10/90.

In einer weiteren Ausführungsform der vorliegenden Erfindung umfasst der erfindungsgemäße cadmiumfreie Kern-Multischalen-Quantenpunkt einen Kern umfassend Indiumphosphid, vorzugsweise einen Kern umfassend Indiumphosphid und Zinksulfid und Zinkselenid, eine über der Oberfläche des Kerns aufgewachsene erste Schale umfassend Zinkselenid und Zinksulfid und eine über der Oberfläche der ersten Schale aufgewachsene zweite Schale umfassend Zinkselenid oder Zinksulfid, vorzugsweise Zinksulfid. Umfasst das erste Material der ersten Schale Zinkselenid und Zinksulfid, liegt das Gewichtsverhältnis von Zinkselenid zu Zinksulfid in der ersten Schale vorzugsweise in einem Bereich zwischen 99/1 und 1/99, weiter bevorzugt in einem Bereich zwischen 90/10 und 10/90.

Prinzipiell gibt es mehrere Möglichkeiten, die erfindungsgemäßen cadmiumfreien Kern-Multischalen-Quantenpunkte herzustellen.

Allgemein ist bisher kein Verfahren bekannt, mit deren Hilfe in einem Ein-Topf-Verfahren, d. h. ohne Reinigungsprozesse nach den jeweiligen Zwischenschritten (Wachstum der ersten Schale, Wachstum jeweils weiterer Schalen), hochlumineszente und stabile Kern-Multischalen-Quantenpunkte auf Basis von Indiumphosphid bereitgestellt werden können.

Das Verfahren zur Herstellung dieser cadmiumfreien Kern-Multischalen-Quantenpunkten umfasst in einem Schritt a) das Bereitstellen einer Rohlösung umfassend Indiumphosphid-Nanopartikel.

Die Rohlösung umfassend Indiumphosphid-Nanopartikel wird vorzugsweise erhalten durch das Inkontaktbringen eines Indium(III)salzes mit mindestens einer Carbonsäure (Schritt i).

Als Indium(III)salze können alle Indiumsalze verwendet werden, die eine ausreichende Reaktivität aufweisen, um das entsprechende Indium(III)carboxylat zu erhalten.

Besonders bevorzugte Indium(III)salze sind ausgewählt aus der Gruppe umfassend Indium(III)acetat, Indium(III)fluorid, Indium(III)chlorid, Indium(III)bromid, Indium(III)iodid, Indium(III)nitrat, Indium(III)triflat, Indium(III)tosylat, Indium(III)mesylat, Indium(III)sulfat, Indium(III)acetylacetonat, Indium(III)-tert-butoxid, Indium(III)hydroxid, Indium(III)perchlorat, Indium(III)sulfid und Gemische von diesen.

Als Carbonsäuren können alle Verbindungen eingesetzt werden, die eine ausreichende Reaktivität aufweisen, um das entsprechende Indium(III)carboxylat zu erhalten.

Besonders bevorzugte Carbonsäuren sind ausgewählt aus der Gruppe umfassend Essigsäure, Propionsäure, Buttersäure, Valeriansäure, Capronsäure, Heptansäure, Caprylsäure, Caprinsäure, Laurinsäure, Myristinsäure, Palmitinsäure, Stearinsäure, Behensäure, Acrylsäure, Methacrylsäure, But-2-ensäure, But-3-ensäure, Pent-2-ensäure, Pent-4-ensäure, Hex-2-ensäure, Hex-3-ensäure, Hex-4-ensäure, Hex-5-ensäure, Hept-6-ensäure, Oct-2-ensäure, Dec-2-ensäure, Undec-10-ensäure, Dodec-5-ensäure, Ölsäure, Gadoleinsäure, Erucasäure, Linolsäure, α-Linolensäure, γ-Linolensäure, Calendulasäure, Eicosadiensäure, Eicosatriensäure, Arachidonsäure, Stearidonsäure, Benzoesäure, *para*-Toluinsäure, *ortho*-Toluinsäure, *meta-*Toluinsäure, Hydrozimtsäure, Naphtensäure, Zimtsäure und Gemische von diesen.

Die aufgeführten Indium(III)salze und Carbonsäuren können in jeglicher Form kombiniert und verwendet werden.

Um das Indium(III)salz in das entsprechende Indium(III)carboxylat zu überführen, können übliche, dem Fachmann bekannte Verfahren verwendet werden.

Das entsprechende Indium(III)carboxylat kann sowohl *ex situ* als auch *in situ* hergestellt werden.

Beispielsweise erfolgt die Überführung des Indium(III)salz in das entsprechende Indium(III)carboxylat durch Mischen des Indium(III)salzes und der Carbonsäure in einem Lösungsmittel. Als Lösungsmittel können alle Lösungsmittel verwendet werden, die eine Überführung des Indium(III)salzes in Verbindung mit einer Carbonsäure in das entsprechende Indium(III)carboxylat erlauben. Besonders bevorzugte Lösungsmittel sind organische Lösungsmittel. Insbesondere kann das organische Lösungsmittel ausgewählt sein aus Kohlenwasserstoffen mit einem Siedepunkt von mindestens 250 °C und weiter bevorzugt von mindestens 300 °C bei Normaldruck. Beispielsweise kann das organische Lösungsmittel ausgewählt sein aus Octadecen und Paraffinöl, vorzugsweise Octadecen.

Vorzugsweise wird die Temperatur so ausgewählt, dass eine quantitative Umsetzung erfolgt, beispielsweise bei Raumtemperatur oder erhöhte Temperatur. In einer bevorzugten Ausführungsform, wird die Mischung umfassend Indium(III)salz, Carbonsäure und Lösungsmittel erhitzt. Beispielsweise wird die Mischung auf eine Temperatur in einem Bereich von 30 bis 320 °C erhitzt, weiter bevorzugt in einem Bereich von 50 bis 150 °C und noch weiter bevorzugt in einem Bereich von 70 bis 120 °C.

Ferner kann die Umsetzung zu Indium(III)carboxylat unter Vakuum, z.B. dynamischem Vakuum erfolgen. Zusätzlich oder alternativ kann die Umsetzung zu Indium(III)carboxylat unter Rühren erfolgen.

Prinzipiell kann nach diesem Verfahren eine Indiumcarboxylat-Stammlösung mit allen oben aufgeführten Indium(III)salzen und Carbonsäuren hergestellt werden. Beispielsweise kann die Carbonsäure in einem Mengenverhältnis von 3 bis 4 Moläquivalente im Verhältnis zum eingesetzten Indium(III)salz eingesetzt werden. Vorzugsweise wird die Carbonsäure in einem Mengenverhältnis von etwa 3,5 Moläquivalente im Verhältnis zum eingesetzten Indium(III)salz eingesetzt.

Alternativ erfolgt die Überführung des Indium(III)salzes in das entsprechende Indium(III)carboxylat durch Mischen des entsprechenden Indium(III)salzes in wässriger Lösung mit einem entsprechenden Natriumcarboxylat. Das Natriumcarboxylat kann durch Umsetzung der entsprechenden Carbonsäure mit Natriumhydroxid erhalten werden, beispielsweise unter Raumtemperatur oder erhöhter Temperatur, wie z.B. einer Temperatur in einem Bereich von 30 bis 80 °C oder in einem Bereich von 40 bis 60 °C.

Prinzipiell kann nach diesem Verfahren ein Indiumcarboxylat-Pulver mit allen oben aufgeführten Indium(III)salzen und Carbonsäuren hergestellt werden. Beispielsweise kann die Carbonsäure in einem Mengenverhältnis von 1 bis 4 Moläquivalente im Verhältnis zum eingesetzten Indium(III)salz eingesetzt werden. Vorzugsweise wird die Carbonsäure in einem Mengenverhältnis von etwa 1 bis 3 Moläquivalente im Verhältnis zum eingesetzten Indium(III)salz eingesetzt.

Um eine Rohlösung umfassend Indiumphosphid-Nanopartikel zu erhalten, wird das erhaltene Indium(III)carboxylat mit mindestens einem Zinkcarboxylat in Kontakt gebracht (Schritt ii)).

Das Zinkcarboxylat wird vorzugsweise durch das Inkontaktbringen eines Zinksalzes mit mindestens einer Carbonsäure erhalten.

Als Zinksalz können alle Zinksalze verwendet werden, die eine ausreichende Reaktivität aufweisen, um das entsprechende Zinkcarboxylat zu erhalten.

Besonders bevorzugte Zinksalze sind ausgewählt aus der Gruppe umfassend Zinkacetat, Zinkfluorid, Zinkchlorid, Zinkbromid, Zinkiodid, Zinknitrat, Zinktriflat, Zinktosylat, Zinkmesylat, Zinkoxid, Zinksulfat, Zinkacetylacetonat, Zink(Toluol-3,4-dithiolat), Zink (p-Toluol-sulfonat), Zinkdiethyl-dithio-carbamat, Zinkdibenzyl-dithiocarbamat und Gemische von diesen.

Als Carbonsäuren können alle Verbindungen eingesetzt werden, die eine ausreichende Reaktivität aufweisen, um das entsprechende Zinkcarboxylat zu erhalten.

Besonders bevorzugte Carbonsäuren sind ausgewählt aus der Gruppe umfassend Essigsäure, Propionsäure, Buttersäure, Valeriansäure, Capronsäure, Heptansäure, Caprylsäure, Caprinsäure, Undecansäure, Laurinsäure, Myristinsäure, Palmitinsäure, Stearinsäure, Behensäure, Acrylsäure, Methacrylsäure, But-2-ensäure, But-3-ensäure, Pent-2-ensäure, Pent-4-ensäure, Hex-2-ensäure, Hex-3-ensäure, Hex-4-ensäure, Hex-5-ensäure, Hept-6-ensäure, Oct-2-ensäure, Dec-2-ensäure, Undec-10-ensäure, Dodec-5-ensäure, Ölsäure, Gadoleinsäure, Erucasäure, Linolsäure, α-Linolensäure, γ-Linolensäure, Calendulasäure, Eicosadiensäure, Eicosatriensäure, Arachidonsäure, Stearidonsäure, Benzoesäure, *para*-Toluinsäure, *ortho*-Toluinsäure, *meta*-Toluinsäure, Hydrozimtsäure, Naphtensäure, Zimtsäure, *para-*Toluolsulfonsäure und Gemische von diesen.

Die aufgeführten Zinksalze und Carbonsäuren können in jeglicher Form kombiniert und verwendet werden.

Um das Zinksalz in das entsprechende Zinkcarboxylat zu überführen, können übliche, dem Fachmann bekannte Verfahren verwendet werden.

Beispielsweise erfolgt die Überführung des Zinksalzes in das entsprechende Zinkcarboxylat durch Mischen des Zinksalzes und der Carbonsäure in einem Lösungsmittel. Als Lösungsmittel können alle Lösungsmittel verwendet werden, die eine Überführung des Zinksalzes in Verbindung mit einer Carbonsäure in das entsprechende Zinkcarboxylat erlauben. Besonders bevorzugte Lösungsmittel sind organische Lösungsmittel. Insbesondere kann das organische Lösungsmittel ausgewählt sein aus Kohlenwasserstoffen mit einem Siedepunkt von mindestens 250 °C und weiter bevorzugt von mindestens 300 °C bei Normaldruck. Beispielsweise kann das organische Lösungsmittel ausgewählt sein aus Octadecen und Paraffinöl, vorzugsweise Octadecen.

In einer bevorzugten Ausführungsform, wird die Mischung erhitzt. Vorzugsweise wird die Temperatur so ausgewählt, dass eine quantitative Umsetzung erfolgt. Beispielsweise wird die Mischung auf eine Temperatur in einem Bereich von 30 bis 320 °C erhitzt, bevorzugt in einem Bereich von 50 bis 150 °C und noch weiter bevorzugt in einem Bereich von 70 bis 120 °C.

Ferner kann die Umsetzung zu Zinkcarboxylat unter Vakuum, z.B. dynamischem Vakuum erfolgen. Zusätzlich oder alternativ kann die Umsetzung zu Zinkcarboxylat unter Rühren erfolgen.

Prinzipiell kann nach diesem Verfahren eine Zinkcarboxylat-Stammlösung aus allen oben aufgeführten Zinksalzen und Carbonsäuren hergestellt werden. Beispielsweise kann die Carbonsäure in einem Mengenverhältnis von 1 bis 3 Moläquivalente im Verhältnis zum eingesetzten Zinksalz eingesetzt werden. Vorzugsweise wird die Carbonsäure in einem Mengenverhältnis von etwa 2 Moläquivalente im Verhältnis zum eingesetzten Zinksalz eingesetzt.

Alternativ erfolgt die Überführung des Zinksalzes in das entsprechende Zinkcarboxylat durch Mischen des entsprechenden Zinksalzes in wässriger Lösung mit einem entsprechenden Natriumcarboxylat. Das Natriumcarboxylat kann durch Umsetzung der entsprechenden Carbonsäure mit Natriumhydroxid erhalten werden, beispielsweise unter Raumtemperatur oder erhöhter Temperatur, wie z.B. einer Temperatur in einem Bereich von 20 bis 100 °C, bevorzugt in einem Bereich von 30 bis 80 °C oder in einem Bereich von 40 bis 60 °C.

Prinzipiell kann nach diesem Verfahren ein Zinkcarboxylat-Pulver aus allen oben aufgeführten Zinksalzen und Carbonsäuren hergestellt werden. Beispielsweise kann die Carbonsäure in einem Mengenverhältnis von 1 bis 4 Moläquivalente im Verhältnis zum eingesetzten Zinksalz eingesetzt werden. Vorzugsweise wird die Carbonsäure in einem Mengenverhältnis von 1 bis 2 Moläquivalente im Verhältnis zum eingesetzten Zinksalz eingesetzt.

Alternativ erfolgt die Überführung des Zinksalzes in das entsprechende Zinkcarboxylat durch Mischen von Zinkoxid in einem organischen Lösungsmittel, beispielsweise aliphatisch und/oder aromatisch, mit einer entsprechenden Carbonsäure.

Prinzipiell kann nach diesem Verfahren ein Zinkcarboxylat-Pulver aus Zinkoxid und allen oben aufgeführten Carbonsäuren hergestellt werden. Beispielsweise kann die Carbonsäure in einem Mengenverhältnis von 1 bis 4 Moläquivalente im Verhältnis zum eingesetzten Zinkoxi eingesetzt werden. Vorzugsweise wird die Carbonsäure in einem Mengenverhältnis von 1 bis 2 Moläquivalente im Verhältnis zum eingesetzten Zinkoxid eingesetzt.

Wie bereits oben erwähnt, wird das erhaltene Indium(III)carboxylat mit mindestens einem entsprechenden Zinkcarboxylat in Kontakt gebracht (Schritt ii)).

Dabei werden das entsprechende Indium(III)carboxylat und das entsprechende Zinkcarboxylat in einem Lösungsmittel dispergiert. Als Lösungsmittel können alle organischen Lösungsmittel verwendet werden. Insbesondere kann das organische Lösungsmittel ausgewählt sein aus Kohlenwasserstoffen mit einem Siedepunkt von mindestens 250 °C und weiter bevorzugt von mindestens 300 °C bei Normaldruck. Beispielsweise kann das organische Lösungsmittel ausgewählt sein aus Octadecen und Paraffinöl, vorzugsweise Octadecen.

In einer bevorzugten Ausführungsform der vorliegenden Erfindung wird dem Lösungsmittel, umfassend das entsprechende Indium(III)carboxylat und das entsprechende Zinkcarboxylat, ein Co-Reagenz zugesetzt. Vorzugsweise kann das Co-Reagenz ausgewählt sein aus der Gruppe umfassend 1-Dodecanthiol, Octadecanthiol, Octanthiol und Gemische von diesen.

Um das Indium(III)carboxylat und das entsprechende Zinkcarboxylat in dem organischen Lösungsmittel zu dispergieren, können übliche, dem Fachmann bekannte Verfahren verwendet werden.

Vorzugsweise wird die erhaltene Mischung bei Raumtemperatur oder erhöhter Temperatur gerührt. Beispielsweise wird die Mischung bei einer Temperatur in einem Bereich von 50 bis 250 °C, bevorzugt in einem Bereich von 50 bis 180 °C und weiter bevorzugt in einem Bereich von 90 bis 160 °C gerührt.

Ferner kann das Rühren der erhaltenen Mischung unter Vakuum, z.B. dynamischem Vakuum, erfolgen. Zusätzlich oder alternativ kann das Rühren der erhaltenen Mischung in einer inerten Atmosphäre erfolgen, wie beispielsweise einer Atmosphäre aus Argon, Stickstoff oder Helium.

Das Indiumcarboxylat wird vorzugsweise in einem Mengenverhältnis von 0.2 bis 2 Moläquivalente im Verhältnis zum eingesetzten Zinkcarboxylat eingesetzt. Vorzugsweise wird das Indiumcarboxylat in einem Mengenverhältnis von etwa 0,2 bis 1 oder 0,5 bis 1 Moläquivalente im Verhältnis zum eingesetzten Zinkcarboxylat eingesetzt.

Die so erhaltene Mischung wird ferner mit Tris(trimethylsilyl)phosphin in Kontakt gebracht (Schritt iii)), um so eine Rohlösung umfassend Indiumphosphid-Nanopartikel zu erhalten. Dafür können übliche, dem Fachmann bekannte Verfahren verwendet werden.

Beispielsweise kann Tris(trimethylsilyl)phosphin bei Raumtemperatur oder erhöhter Temperatur zu der Mischung gegeben werden. In einer bevorzugten Ausführungsform der vorliegenden Erfindung wird Tris(trimethylsilyl)phosphin bei Raumtemperatur zu der Mischung aus Indium(III)carboxylat und Zinkcarboxylat in einem organischen Lösungsmittel gegeben. Alternativ wird Tris(trimethylsilyl)phosphin bei einer Temperatur in einem Bereich von 80 bis 120 °C, bevorzugt in einem Bereich von 90 bis 110 °C zu der Mischung aus Indium(III)carboxylat und Zinkcarboxylat in einem organischen Lösungsmittel gegeben.

In einer bevorzugten Ausführungsform der vorliegenden Erfindung wird die Mischung auf eine Temperatur in einem Bereich von 180 °C bis 320 °C, bevorzugt in einem Bereich von 240 °C bis 310 °C erhitzt.

Vorzugsweise wird die Mischung für mindestens 5 Minuten, bevorzugt mindestens 15 Minuten auf eine Temperatur in einem Bereich von 180 °C bis 320 °C, bevorzugt in einem Bereich von 240 °C bis 310 °C erhitzt. Beispielsweise wird die Mischung für 5 bis 90 Minuten, bevorzugt zwischen 15 und 75 Minuten auf eine Temperatur in einem Bereich von 180 °C bis 320 °C, bevorzugt in einem Bereich von 240 °C bis 310 °C erhitzt.

Das erfindungsgemäße Verfahren zur Herstellung der cadmiumfreien Kern-Multischalen-Quantenpunkten umfasst ferner in einem Schritt b) das Bereitstellen mindestens eines Zinkcarboxylats.

Das Zinkcarboxylat wird vorzugsweise durch das Inkontaktbringen eines Zinksalzes mit mindestens einer Carbonsäure erhalten.

Als Zinksalz können alle Zinksalze verwendet werden, die eine ausreichende Reaktivität aufweisen, um das entsprechende Zinkcarboxylat zu erhalten. Diesbezüglich wird auf die Ausführungen oben verwiesen. Als Carbonsäuren können alle Verbindungen eingesetzt werden, die eine ausreichende Reaktivität aufweisen, um das entsprechende Zinkcarboxylat zu erhalten. Diesbezüglich wird ebenfalls auf die Ausführungen oben verwiesen.

Die aufgeführten Zinksalze und Carbonsäuren können in jeglicher Form kombiniert und verwendet werden. Um das Zinksalz in das entsprechende Zinkcarboxylat zu überführen, können übliche, dem Fachmann bekannte Verfahren verwendet werden. Besonders bevorzugte Verfahren wurden bereits oben beschrieben.

Das erfindungsgemäße Verfahren zur Herstellung der cadmiumfreien Kern-Multischalen-Quantenpunkten umfasst ferner in einem Schritt c) das Bereitstellen mindestens einer Schwefel- oder Selenquelle.

Als Schwefel- oder Selenquelle können alle Verbindungen verwendet werden, die eine ausreichende Reaktivität aufweisen, um das entsprechende Zinksulfid bzw. Zinkselenid zu erhalten.

Besonders bevorzugte Schwefel- oder Selenquellen sind ausgewählt aus der Gruppe umfassend elementarer Schwefel, Octanthiol, Dodecanthiol, Octadecanthiol, *tert-*Butandion, Tributylphosphansulfid, Cyclohexylisothiocyanat, α-Toluolthiol, Ethylentrithiocarbonat, Allylmercaptan, Bis(trimethylsilyl)sulfid, Trioctylphosphansulfid, Trioctylphosphinselenid und Gemische von diesen.

Erfindungsgemäß umfasst das Verfahren zur Herstellung der cadmiumfreien Kern-Multischalen-Quantenpunkten in einem Schritt d) das Inkontaktbringen der Rohlösung umfassend Indiumphosphid-Nanopartikel aus Schritt a) mit mindestens einem Zinkcarboxylat aus Schritt b).

Beispielsweise kann die Rohlösung umfassend Indiumphosphid-Nanopartikel bei Raumtemperatur oder erhöhter Temperatur mit einem Zinkcarboxylat aus Schritt b) versetzt werden. In einer bevorzugten Ausführungsform der vorliegenden Erfindung erfolgt das Inkontaktbringen der Rohlösung umfassend Indiumphosphid-Nanopartikel aus Schritt a) mit mindestens einem Zinkcarboxylat aus Schritt b) bei Raumtemperatur. Alternativ erfolgt das Inkontaktbringen der Rohlösung mit einem Zinkcarboxylat bei einer Temperatur in einem Bereich von 10 bis 320 °C, bevorzugt in einem Bereich von 20 bis 250 °C, weiter bevorzugt einem Bereich von 30 bis 120 °C und am meisten bevorzugt in einem Bereich von 40 bis 100 °C.

Ferner kann das Inkontaktbringen der Rohlösung umfassend Indiumphosphid-Nanopartikel aus Schritt a) mit mindestens einem Zinkcarboxylat aus Schritt b) in einer inerten Atmosphäre erfolgen, wie beispielsweise einer Atmosphäre aus Argon, Stickstoff oder Helium.

In einer bevorzugten Ausführungsform der vorliegenden Erfindung wird die Mischung auf eine Temperatur in einem Bereich von 10 °C bis 320 °C, bevorzugt in einem Bereich von 20 bis 250 °C erhitzt. Beispielsweise wird die Mischung auf eine Temperatur in einem Bereich von 50 °C bis 200 °C erhitzt.

Erfindungsgemäß umfasst das Verfahren zur Herstellung der cadmiumfreien Kern-Multischalen-Quantenpunkten in einem Schritt e) das Inkontaktbringen der aus Schritt d) erhaltenen Mischung mit mindestens einer Schwefel- oder Selenquelle aus Schritt c).

Um die Mischung mit mindestens einer Schwefel- oder Selenquelle in Kontakt zu bringen, können übliche, dem Fachmann bekannte Verfahren verwendet werden.

In einer bevorzugten Ausführungsform erfolgt das Inkontaktbringen der aus Schritt d) erhaltenen Mischung mit mindestens einer Schwefel- oder Selenquelle aus Schritt c) bei erhöhter Temperatur. Beispielsweise wird die mindestens eine Schwefel- oder Selenquelle bei einer Temperatur in einem Bereich von 10 °C bis 320 °C, bevorzugt in einem Bereich von 20 °C bis 250 °C zu der Mischung hinzugegeben. Beispielsweise wird die mindestens eine Schwefel- oder Selenquelle bei einer Temperatur in einem Bereich von 120 °C bis 170 °C oder in einem Bereich von 130 °C bis 160 °C zu der Mischung hinzugegeben.

In einer bevorzugten Ausführungsform der vorliegenden Erfindung wird die erhaltene Mischung auf eine Temperatur in einem Bereich von 180 °C bis 320 °C, bevorzugt in einem Bereich von 240 °C bis 310 °C erhitzt.

Vorzugsweise wird die Mischung für mindestens 5 Minuten, bevorzugt mindestens 15 Minuten auf eine Temperatur in einem Bereich von 180 °C bis 320 °C, bevorzugt in einem Bereich von 240 °C bis 310 °C erhitzt. Beispielsweise wird die Mischung für 5 bis 90 Minuten, bevorzugt zwischen 15 und 75 Minuten auf eine Temperatur in einem Bereich von 180 °C bis 320 °C, bevorzugt in einem Bereich von 240 °C bis 310 °C erhitzt.

Erfindungsgemäß umfasst das Verfahren zur Herstellung der cadmiumfreien Kern-Multischalen-Quantenpunkten ferner in einem Schritt f) das Inkontaktbringen der erhaltenen Mischung aus Schritt e) mit mindestens einem Zinkcarboxylat aus Schritt b).

Beispielsweise kann die erhaltene Mischung aus Schritt e) bei Raumtemperatur oder erhöhter Temperatur mit einem Zinkcarboxylat aus Schritt b) versetzt werden. In einer bevorzugten Ausführungsform der vorliegenden Erfindung erfolgt das Inkontaktbringen der erhaltenen Mischung aus Schritt e) mit mindestens einem Zinkcarboxylat aus Schritt b) bei Raumtemperatur. Alternativ erfolgt das Inkontaktbringen der erhaltenen Mischung aus Schritt e) mit einem Zinkcarboxylat bei einer Temperatur in einem Bereich von 10 bis 320 °C, bevorzugt in einem Bereich von 20 bis 250 °C, weiter bevorzugt einem Bereich von 30 bis 120 °C und am meisten bevorzugt in einem Bereich von 40 bis 100 °C.

Ferner kann das Inkontaktbringen der erhaltenen Mischung aus Schritt e) mit mindestens einem Zinkcarboxylat aus Schritt b) in einer inerten Atmosphäre erfolgen, wie beispielsweise einer Atmosphäre aus Argon, Stickstoff oder Helium.

In einer bevorzugten Ausführungsform der vorliegenden Erfindung wird die Mischung auf eine Temperatur in einem Bereich von 10 °C bis 320 °C, bevorzugt in einem Bereich von 20 bis 250 °C erhitzt. Beispielsweise wird die Mischung auf eine Temperatur in einem Bereich von 50 °C bis 200 °C erhitzt.

Erfindungsgemäß umfasst das Verfahren zur Herstellung der cadmiumfreien Kern-Multischalen-Quantenpunkten in einem Schritt g) das Inkontaktbringen der aus Schritt f) erhaltenen Mischung mit mindestens einer Schwefel- oder Selenquelle aus Schritt c).

Um die erhaltene Mischung mit mindestens einer Schwefel- oder Selenquelle in Kontakt zu bringen, können übliche, dem Fachmann bekannte Verfahren verwendet werden.

In einer bevorzugten Ausführungsform erfolgt das Inkontaktbringen der aus Schritt f) erhaltenen Mischung mit mindestens einer Schwefel- oder Selenquelle aus Schritt c) bei erhöhter Temperatur. Beispielsweise wird die mindestens eine Schwefel- oder Selenquelle bei einer Temperatur in einem Bereich von 10 °C bis 320 °C, bevorzugt in einem Bereich von 20 °C bis 250 °C zu der Mischung hinzugegeben. Beispielsweise wird die mindestens eine Schwefel- oder Selenquelle bei einer Temperatur in einem Bereich von 120 °C bis 170 °C oder in einem Bereich von 130 °C bis 160 °C zu der Mischung hinzugegeben.

In einer bevorzugten Ausführungsform der vorliegenden Erfindung wird die erhaltene Mischung auf eine Temperatur in einem Bereich von 180 °C bis 320 °C, bevorzugt in einem Bereich von 240 °C bis 310 °C erhitzt.

Vorzugsweise wird die Mischung für mindestens 5 Minuten, bevorzugt mindestens 15 Minuten auf eine Temperatur in einem Bereich von 180 °C bis 320 °C, bevorzugt in einem Bereich von 240 °C bis 310 °C erhitzt. Beispielsweise wird die Mischung für 5 bis 90 Minuten, bevorzugt zwischen 15 und 75 Minuten auf eine Temperatur in einem Bereich von 180 °C bis 320 °C, bevorzugt in einem Bereich von 240 °C bis 310 °C erhitzt.

Weitere Schalen können nach dem zuvor beschriebenen Verfahren auf dem cadmiumfreien Kern-Multischalen-Quantenpunkt aufgewachsen werden.

Das dargestellte Verfahren bietet insbesondere den Vorteil, dass der erfindungsgemäße cadmiumfreie Kern-Multischalen-Quantenpunkt in einem Ein-Topf-Verfahren hergestellt werden kann. D. h. der erfindungsgemäße cadmiumfreie Kern-Multischalen-Quantenpunkt kann ohne Reinigungsprozesse nach den jeweiligen Zwischenschritten (Wachstum der ersten Schale, Wachstum jeweils weiterer Schalen) hergestellt werden.

Die erfindungsgemäßen cadmiumfreien Kern-Multischalen-Quantenpunkte können aufgrund ihrer vorteilhaften Eigenschaften insbesondere in OLEDs, hybriden QDorganischen Solarzellen, als stabile Fluoreszenzmarker in der Bioanalytik, in Fluoreszenzkollektoren durch Einbettung in transparente organische Matrices, in der Sicherheitstechnologie als lumineszierendes Sicherheitsmerkmal, in neuartigen Röntgenstrahl-Szintillatoren, in organischen Feldeffekttransistoren und in der Beleuchtungstechnik eingesetzt werden.

Optoelektronische Bauelemente, in denen die erfindungsgemäßen cadmiumfreien Kern-Multischalen-Quantenpunkte eingesetzt werden, zeigen insbesondere eine günstige schmalbandige Elektrolumineszenz.

Die Ausgestaltungen des cadmiumfreien Kern-Multischalen-Quantenpunktes gelten auch für das Verfahren zur Herstellung der cadmiumfreien Kern-Multischalen-Quantenpunkte sowie die Verwendungen und umgekehrt.

### Kurze Beschreibung der Figuren

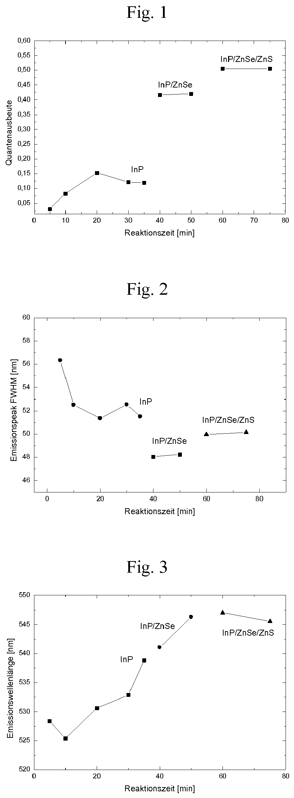

**Fig. 1** zeigt den Verlauf der Quanteneffizienz während der Reaktionszeit für die aus dem Verfahren erhältlichen cadmiumfreien Kern-Multischalen-Quantenpunkte (InP/ZnSe/ZnS) im Vergleich zu einem Indiumphoshid-Nanopartikel (InP) und einem Indiumphoshid-Nanopartikel mit Zinkselenid-Einfachschale (InP/ZnSe).
**Fig. 2** zeigt den Verlauf der Halbwertsbreite der Emission für die aus dem Verfahren erhältlichen cadmiumfreien Kern-Multischalen-Quantenpunkte (InP/ZnSe/ZnS) im Vergleich zu einem Indiumphoshid-Nanopartikel (InP) und einem Indiumphoshid-Nanopartikel mit Zinkselenid-Einfachschale (InP/ZnS).
**Fig. 3** zeigt den Verlauf der Emissionswellenlänge für die aus dem Verfahren erhältlichen cadmiumfreien Kern-Multischalen-Quantenpunkte (InP/ZnSe/ZnS) im Vergleich zu einem Indiumphoshid-Nanopartikel (InP) und einem Indiumphoshid-Nanopartikel mit Zinkselenid-Einfachschale (InP/ZnS).

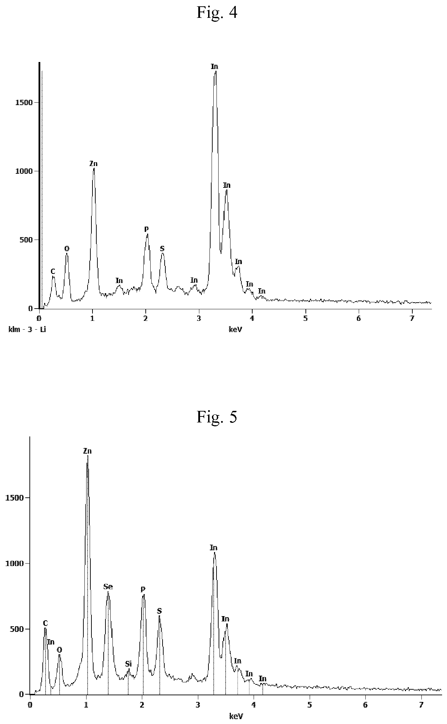

**Fig. 4** zeigt ein Röntgenspektrum (SEM-EDX) eines Films der aufgereinigten Kern-Nanopartikel von einem aus dem erfindungsgemäßen Verfahren erhältlichen cadmiumfreien Kern-Multischalen-Quantenpunktes. Die aufgereinigten Kern-Nanopartikel aus Beispiel 1 wurden durch Aufreinigung eines Teils des Reaktionsgemisches nach der Kernsynthese, aber vor den Schalensyntheseschritten erhalten.
**Fig. 5** zeigt ein Röntgenspektrum (SEM-EDX) eines Films der aufgereinigten Kern/Schale1-Nanopartikel von einem aus dem erfindungsgemäßen Verfahren erhältlichen cadmiumfreien Kern-Multischalen-Quantenpunktes. Die aufgereinigten Kern/Schale1-Nanopartikel wurden durch Aufreinigung eines Teils des Reaktionsgemisches nach dem ersten Schritt der Synthese der Mehrfachschale auf dem Kern erhalten.

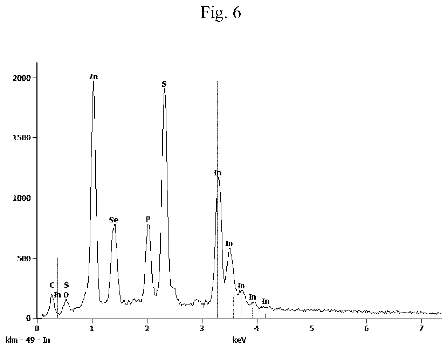

**Fig. 6** zeigt ein Röntgenspektrum (SEM-EDX) eines Films der aufgereinigten Kern/Schalel/Schale2-Nanopartikel von einem aus dem erfindungsgemäßen Verfahren erhältlichen cadmiumfreien Kern-Multischalen-Quantenpunktes. Die aufgereinigten Kern/Schalel/Schale2-Nanopartikel wurden durch Aufreinigung eines Teils des Reaktionsgemisches nach der Synthese der Mehrfachschale auf dem Kern erhalten.

### Ausführungsbeispiel

### Experimentelle Durchführung mit ex situ hergestellten Indium-Edukten:

### Beispiel Imdiumlaurat-Pulver

Indium(III)laurat wurde durch Lösen von Indium(III)chlorid (100 mmol, 2,9 g) in 100 mL destilliertem Wasser und einer Lösung von Laurinsäure (300 mmol, 6,0 g) in 300 mL einer 1 M NaOH-Lösung hergestellt. Dabei wurde die Laurinsäure unter Rühren bei 50 °C in der NaOH-Lösung unter Bildung von Natriumlaurat gelöst. Diese wurde anschließend mit der wässrigen InCl₃-vermengt, wobei sich sofort ein weißer Niederschlag an Indium(II)laurat bildete. Der Niederschlag wurde dann mittels einer Saugflasche und eines Filters von der Lösung abgetrennt und mindestens fünf Mal mit jeweils 100 mL destillierten Wasser nachgewaschen. Das erhaltene weiße Indium(III)laurat wurde anschließend mehrere Stunden bei 50 °C unter Vakuum getrocknet.

### Beispiel Indiummyristat-Stammlösung

Eine Stammlösung von Indiummyristat in 1-Octadecen der Konzentration 01 M wurde durch Mischen von Indium(III)acetat (2 mmol, 584 mg) und Myristinsäure (7mmol, 1,6 g) in Octadecen (20 mL) hergestellt. Durch Rühren bei 110 °C unter dynamischem Vakuum wurde nach mehreren Stunden eine klare Lösung erhalten. Aufgrund der geringen Löslichkeit von Indiummyristat in Octadecen musste die Lösung für die Verwendung bei etwa 80 °C gehalten werden

### Trioctylphosphinselenid-Stammlösung

Eine Stammlösung von Trioctylphosphinselenid in Trioctylphosphin der Konzentration 1 M wurde durch das Auflösen von elementarem Selen (25 mmol, 2,0 g) in Trioctylphosphin (25 mL) hergestellt. Die Mischung wurde für mehrere Stunden bei 60 °C gerührt, bis eine klare Lösung erhalten wurde.

### Experimentelle Durchführung mit ex situ hergestellten Zink-Edukten:

### Beispiel Zinklaurat-Stammlösung

Eine Stammlösung von Zinklaurat in 1 Octadecen der Konzentration 0,1 M wurde durch Mischen von wasserfreiem Zinkacetat (2 mmol, 366 mg) und Laurinsäure (4mmol, 800 mg) in Octadecen (20 mL) hergestellt. Durch Rühren bei 110 °C unter dynamischem Vakuum wurde nach mehreren Stunden eine klare Lösung erhalten. Aufgrund der geringen Löslichkeit von Zinklaurat in Octadecen musste die Lösung für die Verwendung bei etwa 100 °C gehalten werden.

### Beispiel Zinkcaprylat-Pulver

Zinkcaprylat wurde durch Lösen von Zinkacetat Dihydrat (100 mmol, 22 g) in 100 mL destilliertem Wasser und einer Lösung von Caprylsäure (300 mmol, 6,0 g) in 300 mL einer 1 M NaOH-Lösung hergestellt. Dabei wurde die Caprylsäure unter Rühren bei 50 °C in der NaOH-Lösung unter Bildung von Natriumcaprylat gelöst. Diese wurde anschließend mit der wässrigen Zn(OAc)₂-Lösung vermengt, wobei sich sofort ein weißer Niederschlag an Zinkcaprylat bildete. Der Niederschlag wurde dann mittels einer Saugflasche und eines Filters von der Lösung abgetrennt und mindestens fünf Mal mit jeweils 100 mL destilliertem Wasser nachgewaschen. Das erhaltene weiße Zinkcaprylat wurde anschließend mehrere Stunden bei 50 °C unter Vakuum getrocknet.

### Beispiel 1 einer Synthese von InP-Nanopartikeln nach der Aufheiz-Methode

Zinkstearat (0,1 mmol, 63 mg) und 1-Dodecanthiol (0,05 mmol, 12 µL) wurden in einem 100 mL Dreihals-Schlenkkolben vorgelegt. Diese Edukte wurden in 1-Octadecen (ODE, 8 mL) dispergiert. In der Apparatur wurde durch ein dreifaches Evakuieren und Spülen mit Argon eine inerte Atmosphäre erzeugt. Während der weiteren Reaktionsdurchführung wurde ein leichter Argon-Strom angelegt. Anschließend wurden Indiummyristat (0,1 mmol, 1 mL einer 0,1 M Stammlösung in ODE) und Tris(trimethylsilyl)phosphin (P(TMS)₃, 0,1 mmol, 0,1 mL einer 1 M Stammlösung in ODE) hinzugefügt. Die Reaktionsmischung wurde unter kräftigem Rühren innerhalb von drei Minuten von Rumtemperatur auf 300 °C erhitzt und für 30 min. bei dieser Temperatur gehalten. Anschließend wurde der Heizmantel entfernt und das Reaktionsgemisch langsam abgekühlt.

Ein Teil des erhaltenen Reaktionsgemisches wurde zur Abtrennung der Kern-Nanopartikel von der Reaktionslösung mit 40 mL Aceton versetzt und für 5 min bei 4000 rpm zentrifugiert. Der Überstand wurde anschließend abdekantiert und verworfen. Das erhaltene Kern-Nanopartikel-Pulver wurde drei weiteren Reinigungsschritten unterzogen. Jeder Reinigungsschritt umfasste dabei die Zugabe von 20 mL Aceton, das Dispergieren des Pulvers in dem Lösungsmittel durch Ultraschall für 30 s, das Zentrifugieren der Dispersion für 5 min bei 4000 rpm und das Abdekantieren des Überstandes.

Von den erhaltenen Kern-Nanopartikeln wurden Röntgenspektren aufgenommen (s. Fig. 4). Dazu wurde das aufgereinigte Kern-Nanopartikel-Pulver in Toluol gelöst, die erhaltene Probe auf einen Aluminium-Probenträger aufgetropft und anschließend getrocknet. Zur weitgehenden Entfernung organischer Bestandteile wurde die erhaltene Probe schließlich einer thermischen Behandlung bei 500 °C für 30 min unterzogen. Die Aufnahme der Spektren erfolgte bei Raumtemperatur mit einem SEM-EDX (SEM: JSM 6330 F (Jeol, Japan), EDX: Noran System SIX (Thermo Noran, USA)).

### Beispiel 2 einer Synthese von InP-Nanopartikeln nach der Aufheizmethode

Durch Fällungsreaktion hergestelltes Indiumlaurat (0,1 mmol,73 mg) und Zinklaurat (0,2 mmol, 94 mg) wurden zusammen mit Octadecanthiol (ODT, 0,05 mmol, 14 mg) in einem 3-Halsschlenk-kolben in 8 mL ODE bei 100 °C 30 min. unter Vakuum von Luft befreit. Anschließen wurde P(TMS)₃ (1M in ODE, 100 µL) unter Argon-Atmosphäre in die Lösung bei 100 °C injiziert. Die Reaktionslösung wurde für 30 min. bei dieser Temperatur gerührt und anschließend innerhalb von 2-3 min. auf 300 °C mittels einer Heizhaube erhitzt. Die Reaktion wurde 30-60 min bei 300 °C gerührt und danach innerhalb von 10 min auf Raumtemperatur gekühlt.

### Beispiel 3 einer Synthese von InP-Nanopartikeln nach der Aufheizmethode

Indiumacetat (0,1 mmol, 29 mg) wurde zusammen mit Eisessig (0,35 mmol, 20 µL), Zinkcaprylat (0,2 mmol, 60 mg), das durch Fällungsreaktion hergestellt wurde, Octanthiol (0,05 mmol, 9 µL) in 8 mL ODE dispergiert, von Luft im Vakuum befreit und in Argon-Atmosphäre auf 150 °C erhitzt. Diese Temperatur wurde für 30 min gehalten. Anschließend wurde auf Raumtemperatur abgekühlt. Nach Hinzufügen von P(TMS)₃ (1 M Lösung in ODE) wurde die Reaktionslösung innerhalb von 3 Minuten auf 300 °C erhitzt und bei dieser Temperatur eine Stunde lang gerührt. Danach wurde langsam auf Raumtemperatur abgekühlt. Erhalten wurden grün fluoreszierende InP Nanopartikel dispergiert in ODE.

### Synthese einer ZnS-Einfachschale auf InP-Nanopartikeln

Zu einer Rohlösung von InP-Nanopartikeln, die ohne weitere Reinigung aus den oben beschriebenen Synthesen erhalten wurde, wurde bei Raumtemperatur im Argon-Gegenstrom Zinkstearat (0,4 mmol, 253 mg) hinzugefügt. Die Reaktionsmischung wurde anschließend erhitzt und bei 150 °C Cyclohexylisothiocanat (0,2 mmol, 200 µL einer 1 M Stammlösung in ODE) hinzugefügt. Die Temperatur wurde weiter erhöht und für etwa 20 Minuten bei 280 °C gehalten. Anschließend wurde der Heizmantel entfernt und das Reaktionsgemisch langsam abgekühlt.

### Synthese einer ZnSe/ZnS-Mehrfachschale auf InP-Nanopartikeln

Zu einer Rohlösung von InP-Nanopartikeln, die ohne weitere Reinigung aus den oben beschriebenen Synthesen erhalten wurde, wurde bei Raumtemperatur im Argon-Gegenstrom Zinkstearat (0,1 mmol, 63 mg) hinzugefügt. Die Reaktionsmischung wurde anschließend erhitzt und bei etwa 150 °C Trioctylphosphinselenid (0,05 mmol, 50 µL einer 1M Stammlösung in ODE) hinzugefügt. Die Temperatur wurde weiter erhöht und für etwa 20 Minuten bei 280 °C gehalten. Anschließend wurde der Heizmantel entfernt und das Reaktionsgemisch langsam abgekühlt.

Ein Teil des erhaltenen Reaktionsgemisches wurde zur Abtrennung der Kern/Schale1-Nanopartikel von der Reaktionslösung mit 40 mL Aceton versetzt und für 5 min bei 4000 rpm zentrifugiert. Der Überstand wurde anschließend abdekantiert und verworfen. Das erhaltene Kern/Schale1-Nanopartikel-Pulver wurde drei weiteren Reinigungsschritten unterzogen. Jeder Reinigungsschritt umfasste dabei die Zugabe von 20 mL Aceton, das Dispergieren des Pulvers in dem Lösungsmittel durch Ultraschall für 30 s, das Zentrifugieren der Dispersion für 5 min bei 4000 rpm und das Abdekantieren des Überstandes.

Von den erhaltenen Kern/Schale1-Nanopartikeln wurden Röntgenspektren aufgenommen (s. Fig. 5). Dazu wurde das aufgereinigte Kern/Schale1-Nanopartikel-Pulver in Toluol gelöst, die erhaltene Probe auf einen Aluminium-Probenträger aufgetropft und anschließend getrocknet. Zur weitgehenden Entfernung organischer Bestandteile wurde die erhaltene Probe schließlich einer thermischen Behandlung bei 500 °C für 30 min unterzogen. Die Aufnahme der Spektren erfolgte bei Raumtemperatur mit einem SEM-EDX (SEM: JSM 6330 F (Jeol, Japan), EDX: Noran System SIX (Thermo Noran, USA)).

Für die äußere ZnS-Schale wurde bei Raumtemperatur im Argon-Gegenstrom Zinkstearat (0,3 mmol, 189 mg) hinzugefügt. Die Reaktionsmischung wurde anschließend erhitzt und bei etwa 150 °C Cyclohexylisothiocyanat (0,15 mmol, 150 µL einer 1M Stammlösung in ODE) hinzugefügt. Die Temperatur wurde weiter erhöht und für etwa 20 Minuten bei 280 °C gehalten. Anschließend wurde der Heizmantel entfernt und das Reaktionsgemisch langsam abgekühlt.

Ein Teil des erhaltenen Reaktionsgemisches wurde zur Abtrennung der Kern/Schalel/Schale2-Nanopartikel von der Reaktionslösung mit 40 mL Aceton versetzt und für 5 min bei 4000 rpm zentrifugiert. Der Überstand wurde anschließend abdekantiert und verworfen. Das erhaltene Kern/Schalel/Schale2-Nanopartikel-Pulver wurde drei weiteren Reinigungsschritten unterzogen. Jeder Reinigungsschritt umfasste dabei die Zugabe von 20 mL Aceton, das Dispergieren des Pulvers in dem Lösungsmittel durch Ultraschall for 30 s, das Zentrifugieren der Dispersion für 5 min bei 4000 rpm und das Abdekantieren des Überstandes.

Von den erhaltenen Kern/Schalel/Schale2-Nanopartikeln wurden Röntgenspektren aufgenommen (s. Fig. 6). Dazu wurde das aufgereinigte Kern/Schalel/Schale2-Nanopartikel-Pulver in Toluol gelöst, die erhaltene Probe auf einen Aluminium-Probenträger aufgetropft und anschließend getrocknet. Zur weitgehenden Entfernung organischer Bestandteile wurde die erhaltene Probe schließlich einer thermischen Behandlung bei 500 °C für 30 min unterzogen. Die Aufnahme der Spektren erfolgte bei Raumtemperatur mit einem SEM-EDX (SEM: JSM 6330 F (Jeol, Japan), EDX: Noran System SIX (Thermo Noran, USA)).

Die Röntgenspektren zeigen für die aufgereinigten Kern-, Kern/Schale1- und Kern/Schalel/Schale2-Nanopartikel, dass der Kern neben den In- und P-Signalen zusätzlich deutliche Zn- und S-Signale im Spektrum der Kernprobe aufweist (s. Fig. 4 bis 6). Insbesondere zeigt das Röntgenspektrum in Fig. 4, dass der aufgereinigte Kern-Nanopartikel In- und P-Signale sowie Zn- und S-Signale aufweist. Weiter zeigen die Spektren der Fig. 5 und 6 die Änderung der Zusammensetzung der Kern/Schale1-bzw. Kern/Schalel/Schale2-Nanopartikel durch Abscheidung der ZnSe- bzw. ZnS-Schale auf dem Kern. Insbesondere ist festzuhalten, dass der Zn-, Se-, bzw. S-Anteil zunimmt im Vergleich zu InP.

### Ergebnisse

Die UV-Vis- und Photolumineszenz-Spektren zeigen die optischen Eigenschaften der Partikel, insbesondere die schmalbandige Emission sowie die Verschiebung der Emissionswellenlänge während des Wachstums der Kern-Partikel.

Der direkte Vergleich zwischen ZnSe/ZnS-Mehrfachschale und ZnS-Einfachschale wurde mit identischen Synthesebedingungen durchgeführt. Insbesondere wurde dieselbe Precursor-Menge eingesetzt und die Synthese der Einfachschale wurde zweistufig durchgeführt, nur dass in beiden Stufen S-Precursor eingesetzt wurden, während bei der Mehrfachschale in der ersten Stufe Se-Precursor und in der zweiten Stufe S-Precursor eingesetzt wurden.

### Beispielergebnisse einer Synthese von InP-Mehrfachschalen-Nanopartikeln nach der Aufheiz-Methode mit in situ hergestelltem Indiummyristat

Fig. 1 zeigt deutlich, dass mit der Mehrfachschale um etwa 10 Prozentpunkte höhere Quantenausbeuten erzielt werden als mit der Einfachschale. Die geringe Emissions-Halbwertsbreite der Kern-Partikel wird bei beiden Ausführungen nicht verbreitert, im Gegenteil ist bei der Mehrfachschale eher eine Verringerung der Peakbreite zu beobachten (s. Fig. 2). Die Emissionswellenlänge ist für die Mehrfachschale gering rotverschoben im Vergleich zur Einfachschale, was durch die geringere Bandlücke von ZnSe im Vergleich zu ZnS und der dadurch verringerten Einschränkung des Exzitons erklärt werden kann (s. Fig. 3).

Der Einfluss der Mehrfachschalen-Synthese auf die optische Eigenschaften von InP-Kern-Nanopartikeln ist gut reproduzierbar. In 28 Durchführungen der Synthese wurde durchschnittlich eine Verbesserung der Quantenausbeute um den Faktor 4.1±3.0 erzielt. Die absoluten Quantenausbeuten hängen von der Qualität der Kern-Nanopartikel ab. Mit einer geeigneten und reproduzierbaren Methode für deren Synthese konnten zuverlässig Quantenausbeuten im Bereich von 50 bis 75 % erzielt werden. Die Emissionswellenlänge verschiebt sich durch die Mehrfachschale um durchschnittlich 15±8 nm ins Rote, die Halbwertsbreite verändert sich um durchschnittlich -4±7 nm. Insbesondere werden verbesserte Quantenausbeuten sowie schmalere Emissionspeaks mit Kern-Nanopartikeln erhalten, die eine Mischzusammensetzung umfassend Indiumphosphid und Zinksulfid und/oder Zinkselenid aufweisen.

Die Phasenanalyse mittels Röntgen-Pulverdiffraktometrie weist die Bildung der jeweiligen kubischen Zinkblende-Phase für InP, ZnSe und ZnS nach den entsprechenden Syntheseschritten nach.

Die Aufnahmen mittels Transmissionselektronenmikroskopie zeigen die nanopartikuläre Struktur mit sphärischer Partikelform. Die Auswertung von 96 Partikeln lieferte eine durchschnittliche Größe von 4.0±0.4 nm bei einer Emissionswellenlänge von 550 nm, die Größendispersion beträgt 10%.

Die Elementaranalyse mittels energiedispersiver Röntgenspektroskopie bestätigt die Zusammensetzung der Partikel gemäß der Stöchiometrie des Synthese-Ansatzes.

Erste QD-OLED-Devices wurden mit InP/ZnSe/ZnS-Mehfachschalen-Quantenpunkten mit dem Aufbau ITO/PEDOT:PSS/TPD/QDs/TPBI/Ba/Al hergestellt und zeigen deutlich die schmalbandige Elektrolumineszenz der Quantenpunkte bei 530 nm, allerdings nur mit geringer Luminanz (<25 cd/m²).

## Patentansprüche

1. Cadmiumfreier Kern-Multischalen-Quantenpunkt umfassend
a) einen Kern umfassend Indiumphosphid,
b) eine über der Oberfläche des Kerns aufgewachsene erste Schale aus einem ersten Material umfassend Zinkselenid, und
c) eine über der Oberfläche der ersten Schale aufgewachsene zweite Schale aus einem zweiten Material, das ungleich dem ersten Material der ersten Schale ist,
wobei der Gitterkonstanten-Unterschied zwischen dem Kern und der zweiten Schale weniger als 13 % beträgt.

2. Cadmiumfreier Kern-Multischalen-Quantenpunkt nach Anspruch 1, wobei das erste Material der ersten Schale Zinkselenid oder dessen Gemisch mit Zinksulfid umfasst.

3. Cadmiumfreier Kern-Multischalen-Quantenpunkt nach Anspruch 1 oder 2, wobei das zweite Material der zweiten Schale Zinkselenid, Zinksulfid oder deren Gemische umfasst.

4. Cadmiumfreier Kern-Multischalen-Quantenpunkt nach einem der vorstehenden Ansprüche, wobei die erste Schale eine Gitterkonstante aufweist, die zwischen der von Kern und zweiter Schale liegt.

5. Cadmiumfreier Kern-Multischalen-Quantenpunkt nach einem der vorstehenden Ansprüche, wobei der Gitterkonstanten-Unterschied zwischen dem Kern und der ersten Schale zwischen 2 % und 8 %, bevorzugt zwischen 2 % und 6 % und weiter bevorzugt zwischen 3 % und 5 % beträgt.

6. Cadmiumfreier Kern-Multischalen-Quantenpunkt nach einem der vorstehenden Ansprüche, wobei der Gitterkonstanten-Unterschied zwischen der ersten Schale und der zweiten Schale zwischen 3 % und 9 %, bevorzugt zwischen 3 % und 7 % und weiter bevorzugt zwischen 4 % und 6 % beträgt.

7. Cadmiumfreier Kern-Multischalen-Quantenpunkt nach einem der vorstehenden Ansprüche, wobei der Gitterkonstanten-Unterschied zwischen dem Kern und der zweiten Schale zwischen 5 % und 13 %, bevorzugt zwischen 5 % und 12 %, weiter bevorzugt zwischen 5 % und 11 %, noch weiter bevorzugt zwischen 5 % und 10 % und insbesondere zwischen 7 % und 10 % beträgt.

8. Cadmiumfreier Kern-Multischalen-Quantenpunkt nach einem der vorstehenden Ansprüche, wobei das zweite Material der zweiten Schale Zinksulfid umfasst.

9. Verfahren zur Herstellung von cadmiumfreien Kern-Multischalen-Quantenpunkten gemäß einem der Ansprüche 1 bis 8, umfassend:
a) Bereitstellen einer Rohlösung umfassend Indiumphosphid-Nanopartikel,
b) Bereitstellen mindestens eines Zinkcarboxylats,
c) Bereitstellen mindestens einer Schwefel- oder Selenquelle,
d) Inkontaktbringen der Rohlösung umfassend Indiumphosphid-Nanopartikel aus Schritt a) mit mindestens einem Zinkcarboxylat aus Schritt b),
e) Inkontaktbringen der aus Schritt d) erhaltenen Mischung mit mindestens einer Schwefel- oder Selenquelle aus Schritt c), wobei im Schritt e) mindestens eine Selenquelle oder mindestens eine Schwefelquelle und eine Selenquelle verwendet wird,
f) Inkontaktbringen der aus Schritt e) erhaltenen Mischung mit mindestens einem Zinkcarboxylat aus Schritt b), und
g) Inkontaktbringen der aus Schritt f) erhaltenen Mischung mit mindestens einer Schwefel- oder Selenquelle aus Schritt c), wobei im Schritt g) mindestens eine Schwefelquelle oder mindestens eine Schwefelquelle und eine Selenquelle verwendet wird,
wobei die cadmiumfreien Kern-Multischalen-Quantenpunkte in einem Ein-Topf-Verfahren hergestellt werden.

10. Verfahren nach Anspruch 9, wobei die Rohlösung umfassend Indiumphosphid-Nanopartikel erhalten wird durch
i) Inkontaktbringen eines Indium(III)salzes, ausgewählt aus der Gruppe umfassend Indium(III)acetat, Indium(III)fluorid, Indium(III)chlorid, Indium(III)bromid, Indium(III)iodid, Indium(III)nitrat, Indium(III)triflat, Indium(III)tosylat, Indium(III)mesylat, Indium(III)sulfat, Indium(III)acetylacetonat, Indium(III)-*tert*-butoxid, Indium(III)hydroxid, Indium(III)perchlorat, Indium(III)sulfid und Gemische von diesen, mit mindestens einer Carbonsäure, ausgewählt aus der Gruppe umfassend Essigsäure, Propionsäure, Buttersäure, Valeriansäure, Capronsäure, Heptansäure, Caprylsäure, Caprinsäure, Laurinsäure, Myristinsäure, Palmitinsäure, Stearinsäure, Behensäure, Acrylsäure, Methacrylsäure, But-2-ensäure, But-3-ensäure, Pent-2-ensäure, Pent-4-ensäure, Hex-2-ensäure, Hex-3-ensäure, Hex-4-ensäure, Hex-5-ensäure, Hept-6-ensäure, Oct-2-ensäure, Dec-2-ensäure, Undec-10-ensäure, Dodec-5-ensäure, Ölsäure, Gadoleinsäure, Erucasäure, Linolsäure, α-Linolensäure, γ-Linolensäure, Calendulasäure, Eicosadiensäure, Eicosatriensäure, Arachidonsäure, Stearidonsäure, Benzoesäure, *para*-Toluinsäure, *ortho-*Toluinsäure, *meta*-Toluinsäure, Hydrozimtsäure, Naphtensäure, Zimtsäure und Gemische von diesen,
ii) Inkontaktbringen der aus Schritt i) erhaltenen Mischung mit mindestens einem Zinkcarboxylat und
iii) Inkontaktbringen der aus Schritt ii) erhaltenen Mischung mit Tris(trimethylsilyl)phosphin.

11. Verfahren nach Anspruch 9 oder 10, wobei das mindestens eine Zinkcarboxylat erhalten wird durch Inkontaktbringen mindestens eines Zinksalzes, ausgewählt aus der Gruppe umfassend Zinkacetat, Zinkfluorid, Zinkchlorid, Zinkbromid, Zinkiodid, Zinknitrat, Zinktriflat, Zinktosylat, Zinkmesylat, Zinkoxid, Zinksulfat, Zinkacetylacetonat, Zink(Toluol-3,4-dithiolat), Zink (p-Toluol-sulfonat), Zinkdiethyl-dithio-carbamat, Zinkdibenzyl-dithiocarbamat und Gemische von diesen, mit mindestens einer Carbonsäure, ausgewählt aus der Gruppe umfassend Essigsäure, Propionsäure, Buttersäure, Valeriansäure, Capronsäure, Heptansäure, Caprylsäure, Caprinsäure, Undecansäure, Laurinsäure, Myristinsäure, Palmitinsäure, Stearinsäure, Behensäure, Acrylsäure, Methacrylsäure, But-2-ensäure, But-3-ensäure, Pent-2-ensäure, Pent-4-ensäure, Hex-2-ensäure, Hex-3-ensäure, Hex-4-ensäure, Hex-5-ensäure, Hept-6-ensäure, Oct-2-ensäure, Dec-2-ensäure, Undec-10-ensäure, Dodec-5-ensäure, Ölsäure, Gadoleinsäure, Erucasäure, Linolsäure, α-Linolensäure, γ-Linolensäure, Calendulasäure, Eicosadiensäure, Eicosatriensäure, Arachidonsäure, Stearidonsäure, Benzoesäure, *para*-Toluinsäure, *ortho*-Toluinsäure, *meta*-Toluinsäure, Hydrozimtsäure, Naphtensäure, Zimtsäure, *para*-Toluolsulfonsäure und Gemische von diesen, hergestellt wird.

12. Verfahren nach irgendeinem der Ansprüche 9 bis 11, wobei die mindestens eine Schwefel- oder Selenquelle ausgewählt ist aus der Gruppe umfassend elementarer Schwefel, Octanthiol, Dodecanthiol, Octadecanthiol, *tert-*Butandion, Tributylphosphansulfid, Cyclohexylisothiocyanat, α-Toluolthiol, Ethylentrithiocarbonat, Allylmercaptan, Bis(trimethylsilyl)sulfid, Trioctylphosphansulfid, Trioctylphosphinselenid und Gemische von diesen.

13. Verfahren nach irgendeinem der Ansprüche 9 bis 12, wobei die aus Schritt e) und/oder Schritt g) und/oder Schritt iii) erhaltene Mischung auf eine Temperatur in einem Bereich von 180 °C bis 320 °C, bevorzugt in einem Bereich von 240 °C bis 310 °C erhitzt wird.

14. Verwendung eines cadmiumfreien Kern-Multischalen-Quantenpunktes gemäß einem der Ansprüche 1 bis 8 für den Einsatz in OLEDs, Solarzellen, Beleuchtungsmitteln, Röntgenstrahl-Szintillatoren, Fluoreszenzkollektoren, organischen Feldeffekttransistoren, als Fluoreszenzmarker in der Bioanalytik oder als lumineszierendes Sicherheitsmerkmal.

15. Optoelektronisches Bauelement, aufweisend mindestens einen cadmiumfreien Kern-Multischalen-Quantenpunkt nach irgendeinem der Ansprüche 1 bis 8.

## Claims

1. Cadmium-free core-multishell quantum dot comprising
a) a core comprising indium phosphide,
b) a first shell , grown over the surface of the core, of a first material comprising zinc selenide, and
c) a second shell, grown over the surface of the first shell, of a second material distinct from the first material of the first shell,
the lattice constant difference between the core and the second shell being less than 13%.

2. Cadmium-free core-multishell quantum dot according to Claim 1, the first material of the first shell comprising zinc selenide or a mixture thereof with zinc sulphide.

3. Cadmium-free core-multishell quantum dot according to Claim 1 or 2, the second material of the second shell comprising zinc selenide, zinc sulphide or mixtures thereof.

4. Cadmium-free core-multishell quantum dot according to any of the preceding claims, the first shell having a lattice constant which lies between that of core and second shell.

5. Cadmium-free core-multishell quantum dot according to any of the preceding claims, the lattice constant difference between the core and the first shell being between 2% and 8%, preferably between 2% and 6% and more preferably between 3% and 5%.

6. Cadmium-free core-multishell quantum dot according to any of the preceding claims, the lattice constant difference between the first shell and the second shell being between 3% and 9%, preferably between 3% and 7% and more preferably between 4% and 6%.

7. Cadmium-free core-multishell quantum dot according to any of the preceding claims, the lattice constant difference between the core and the second shell being between 5% and 13%, preferably between 5% and 12%, more preferably between 5% and 11%, even more preferably between 5% and 10% and more particularly between 7% and 10%.

8. Cadmium-free core-multishell quantum dot according to any of the preceding claims, the second material of the second shell comprising zinc sulphide.

9. Process for producing cadmium-free core-multishell quantum dots according to any of Claims 1 to 8, comprising:
a) providing a base solution comprising indium phosphide nanoparticles,
b) providing at least one zinc carboxylate,
c) providing at least one sulphur source or selenium source,
d) contacting the base solution comprising indium phosphide nanoparticles from step a) with at least one zinc carboxylate from step b),
e) contacting the mixture obtained from step d) with at least one sulphur source or selenium source from step c), where at least one selenium source or at least one sulphur source and one selenium source is used in step e),
f) contacting the mixture obtained from step e) with at least one zinc carboxylate from step b), and
g) contacting the mixture obtained from step f) with at least one sulphur source or selenium source from step c), where at least one sulphur source or at least one sulphur source and one selenium source is used in step g),
the cadmium-free core-multishell quantum dots being produced in a one-pot process.

10. Process according to Claim 9, where the base solution comprising indium phosphide nanoparticles is obtained by
i) contacting an indium(III) salt selected from the group encompassing indium(III) acetate, indium(III) fluoride, indium(III) chloride, indium(III) bromide, indium(III) iodide, indium(III) nitrate, indium(III) triflate, indium(III) tosylate, indium(III) mesylate, indium(III) sulphate, indium(III) acetylacetonate, indium(III) tert-butoxide, indium(III) hydroxide, indium(III) perchlorate, indium(III) sulphide and mixtures of these with at least one carboxylic acid selected from the group encompassing acetic acid, propionic acid, butyric acid, valeric acid, caproic acid, heptanoic acid, caprylic acid, capric acid, lauric acid, myristic acid, palmitic acid, stearic acid, behenic acid, acrylic acid, methacrylic acid, but-2-enoic acid, but-3-enoic acid, pent-2-enoic acid, pent-4-enoic acid, hex-2-enoic acid, hex-3-enoic acid, hex-4-enoic acid, hex-5-enoic acid, hept-6-enoic acid, oct-2-enoic acid, dec-2-enoic acid, undec-10-enoic acid, dodec-5-enoic acid, oleic acid, gadoleic acid, erucic acid, linoleic acid, α-linolenic acid, γ-linolenic acid, calendic acid, eicosadienoic acid, eicosatrienoic acid, arachidonic acid, stearidonic acid, benzoic acid, *para*-toluic acid, *ortho*-toluic acid, *meta*-toluic acid, hydrocinnamic acid, naphthenic acid, cinnamic acid and mixtures of these,
ii) contacting the mixture obtained from step i) with at least one zinc carboxylate and
iii) contacting the mixture obtained from step ii) with tris(trimethylsilyl)phosphine.

11. Process according to Claim 9 or 10, the at least one zinc carboxylate being obtained by contacting at least one zinc salt selected from the group encompassing zinc acetate, zinc fluoride, zinc chloride, zinc bromide, zinc iodide, zinc nitrate, zinc triflate, zinc tosylate, zinc mesylate, zinc oxide, zinc sulphate, zinc acetylacetonate, zinc toluene-3,4-dithiolate, zinc p-toluenesulphonate, zinc diethyldithiocarbamate, zinc dibenzyldithiocarbamate and mixtures of these with at least one carboxylic acid selected from the group encompassing acetic acid, propionic acid, butyric acid, valeric acid, caproic acid, heptanoic acid, caprylic acid, capric acid, undecanoic acid, lauric acid, myristic acid, palmitic acid, stearic acid, behenic acid, acrylic acid, methacrylic acid, but-2-enoic acid, but-3-enoic acid, pent-2-enoic acid, pent-4-enoic acid, hex-2-enoic acid, hex-3-enoic acid, hex-4-enoic acid, hex-5-enoic acid, hept-6-enoic acid, oct-2-enoic acid, dec-2-enoic acid, undec-10-enoic acid, dodec-5-enoic acid, oleic acid, gadoleic acid, erucic acid, linoleic acid, α-linolenic acid, γ-linolenic acid, calendic acid, eicosadienoic acid, eicosatrienoic acid, arachidonic acid, stearidonic acid, benzoic acid, *para*-toluic acid, *ortho*-toluic acid, *meta-*toluic acid, hydrocinnamic acid, naphthenic acid, cinnamic acid, *para*-toluenesulphonic acid and mixtures of these, is produced.

12. Process according to any one of Claims 9 to 11, the at least one sulphur source or selenium source being selected from the group encompassing elemental sulphur, octanethiol, dodecanethiol, octadecanethiol, *tert-*butanedione, tributylphosphane sulphide, cyclohexyl isothiocyanate, α-toluenethiol, ethylene trithiocarbonate, allyl mercaptan, bis(trimethylsilyl) sulphide, trioctylphosphane sulphide, trioctylphosphine selenide and mixtures of these.

13. Process according to any one of Claims 9 to 12, the mixture obtained from step e) and/or step g) and/or step iii) being heated to a temperature in a range from 180°C to 320°C, preferably in a range from 240 to 310°C.

14. Use of a cadmium-free core-multishell quantum dot according to any of Claims 1 to 8 for use in OLEDs, solar cells, illuminants, X-ray scintillators, fluorescence collectors, organic field effect transistors, as fluorescent labels in bioanalysis or as a luminescent security feature.

15. Optoelectronic component having at least one cadmium-free core-multishell quantum dot according to any one of Claims 1 to 8.

## Revendications

1. Point quantique coeur-multi-enveloppe sans cadmium comprenant
a) un coeur comprenant du phosphure d'indium,
b) une première enveloppe développée sur la surface du coeur composée d'un premier matériau comprenant du séléniure de zinc et
c) une deuxième enveloppe développée sur la surface de la première enveloppe composée d'un deuxième matériau, qui est différent du premier matériau de la première enveloppe,
la différence de constantes de réseau entre le coeur et la deuxième enveloppe étant inférieure à 13%.

2. Point quantique coeur-multi-enveloppe sans cadmium selon la revendication 1, le premier matériau de la première enveloppe comprenant du séléniure de zinc ou un mélange de celui-ci avec du sulfure de zinc.

3. Point quantique coeur-multi-enveloppe sans cadmium selon la revendication 1 ou 2, le deuxième matériau de la deuxième enveloppe comprenant du séléniure de zinc, du sulfure de zinc ou un mélange de ceux-ci.

4. Point quantique coeur-multi-enveloppe sans cadmium selon l'une quelconque des revendications précédentes, la première enveloppe présentant une constante de réseau qui se situe entre celle du coeur et celle de la deuxième enveloppe.

5. Point quantique coeur-multi-enveloppe sans cadmium selon l'une quelconque des revendications précédentes, la différence de constantes de réseau entre le coeur et la première enveloppe se situant entre 2% et 8%, préférablement entre 2% et 6% et plus préférablement entre 3% et 5%.

6. Point quantique coeur-multi-enveloppe sans cadmium selon l'une quelconque des revendications précédentes, la différence de constantes de réseau entre la première enveloppe et la deuxième enveloppe se situant entre 3% et 9%, préférablement entre 3% et 7% et plus préférablement entre 4% et 6%.

7. Point quantique coeur-multi-enveloppe sans cadmium selon l'une quelconque des revendications précédentes, la différence de constantes de réseau entre le coeur et la deuxième enveloppe se situant entre 5% et 13%, préférablement entre 5% et 12% plus préférablement entre 5% et 11%, encore plus préférablement entre 5% et 10% et en particulier entre 7% et 10%.

8. Point quantique coeur-multi-enveloppe sans cadmium selon l'une quelconque des revendications précédentes, le deuxième matériau de la deuxième enveloppe comprenant du sulfure de zinc.

9. Procédé pour la préparation de points quantiques coeur-multi-enveloppe sans cadmium selon l'une quelconque des revendications 1 à 8, comprenant :
a) la mise à disposition d'une solution brute comprenant des nanoparticules de phosphure d'indium,
b) la mise à disposition d'au moins un carboxylate de zinc,
c) la mise à disposition d'au moins une source de soufre ou de sélénium,
d) la mise en contact de la solution brute comprenant des nanoparticules de phosphure d'indium de l'étape a) avec au moins un carboxylate de zinc de l'étape b),
e) la mise en contact du mélange obtenu dans l'étape d) avec au moins une source de soufre ou de sélénium de l'étape c), où dans l'étape e) au moins une source de sélénium ou bien au moins une source de soufre et une source de sélénium est/sont utilisée(s),
f) la mise en contact du mélange obtenu dans l'étape e) avec au moins un carboxylate de zinc de l'étape b) et
g) la mise en contact du mélange obtenu dans l'étape f) avec au moins une source de soufre ou de sélénium de l'étape c), où dans l'étape g) au moins une source de soufre ou bien au moins une source de soufre et une source de sélénium est/sont utilisée(s),
les points quantiques coeur-multi-enveloppe sans cadmium étant préparés dans un procédé à récipient unique.

10. Procédé selon la revendication 9, la solution brute comprenant des nanoparticules de phosphure d'indium étant obtenue par
i) la mise en contact d'un sel d'indium (III), choisi dans le groupe comprenant l'acétate d'indium (III), le fluorure d'indium (III), le chlorure d'indium (III), le bromure d'indium (III), l'iodure d'indium (III), le nitrate d'indium (III), le triflate d'indium (III), le tosylate d'indium (III), le mésylate d'indium (III), le sulfate d'indium (III), l'acétylacétonate d'indium (III), le tert-butoxyde d'indium (III), l'hydroxyde d'indium (III), le perchlorate d'indium (III), le sulfure d'indium (III) et les mélanges de ceux-ci, avec au moins un acide carboxylique, choisi dans le groupe comprenant l'acide acétique, l'acide propionique, l'acide butyrique, l'acide valérique, l'acide caproïque, l'acide heptanoïque, l'acide caprylique, l'acide caprique, l'acide laurique, l'acide myristique, l'acide palmitique, l'acide stéarique, l'acide béhénique, l'acide acrylique, l'acide méthacrylique, l'acide but-2-énoïque, l'acide but-3-énoïque, l'acide pent-2-énoïque, l'acide pent-4-énoïque, l'acide hex-2-énoïque, l'acide hex-3-énoïque, l'acide hex-4-énoïque, l'acide hex-5-énoïque, l'acide hept-6-énoïque, l'acide oct-2-énoïque, l'acide déc-2-énoïque, l'acide undéc-10-énoïque, l'acide dodéc-5-énoïque, l'acide oléique, l'acide gondoïque, l'acide érucique, l'acide linoléique, l'acide α-linolénique, l'acide γ-linolénique, l'acide calendique, l'acide éicosadiénique, l'acide éicosatriénique, l'acide arachidonique, l'acide stéaridonique, l'acide benzoïque, l'acide *para*-toluique, l'acide *ortho-*toluique, l'acide *méta*-toluique, l'acide hydrocinnamique, l'acide naphténique, l'acide cinnamique et les mélanges de ceux-ci,
ii) la mise en contact du mélange obtenu dans l'étape i) avec au moins un carboxylate de zinc et
iii) la mise en contact du mélange obtenu dans l'étape ii) avec de la tris(triméthylsilyl)phosphine.

11. Procédé selon la revendication 9 ou 10, l'au moins un carboxylate de zinc étant obtenu par la mise en contact d'au moins un sel de zinc, choisi dans le groupe comprenant l'acétate de zinc, le fluorure de zinc, le chlorure de zinc, le bromure de zinc, l'iodure de zinc, le nitrate de zinc, le triflate de zinc, le tosylate de zinc, le mésylate de zinc, l'oxyde de zinc, le sulfate de zinc, l'acétylacétonate de zinc, le toluène-3,4-dithiolate de zinc, le p-toluènesulfonate de zinc, le diéthyldithiocarbamate de zinc, le dibenzyldithiocarbamate de zinc et les mélanges de ceux-ci, avec au moins un acide carboxylique choisi dans le groupe comprenant l'acide acétique, l'acide propionique, l'acide butyrique, l'acide valérique, l'acide caproïque, l'acide heptanoïque, l'acide caprylique, l'acide caprique, l'acide undécanoïque, l'acide laurique, l'acide myristique, l'acide palmitique, l'acide stéarique, l'acide béhénique, l'acide acrylique, l'acide méthacrylique, l'acide but-2-énoïque, l'acide but-3-énoïque, l'acide pent-2-énoïque, l'acide pent-4-énoïque, l'acide hex-2-énoïque, l'acide hex-3-énoïque, l'acide hex-4-énoïque, l'acide hex-5-énoïque, l'acide hept-6-énoïque, l'acide oct-2-énoïque, l'acide déc-2énoïque, l'acide undéc-10-énoïque, l'acide dodéc-5-énoïque, l'acide oléique, l'acide gondoïque, l'acide érucique, l'acide linoléique, l'acide α-linolénique, l'acide γ-linolénique, l'acide calendique, l'acide éicosadiénique, l'acide éicosatriénique, l'acide arachidonique, l'acide stéaridonique, l'acide benzoïque, l'acide *para*-toluique, l'acide *ortho-*toluique, *l'acide* méta-toluique, l'acide hydrocinnamique, l'acide naphténique, l'acide cinnamique, l'acide *para*-toluènesulfonique et les mélanges de ceux-ci, est préparé.

12. Procédé selon l'une quelconque des revendications 9 à 11, l'au moins une source de soufre ou de sélénium étant choisie dans le groupe comprenant le soufre élémentaire, l'octanethiol, le dodécanethiol, l'octadécanethiol, la *tert-*butanedione, le sulfure de tributylphosphane, l'isothiocyanate de cyclohexyle, l'α-toluènethiol, le trithiocarbonate d'éthylène, l'allylmercaptan, le sulfure de bis(triméthylsilyle), le sulfure de trioctylphosphane, le séléniure de trioctylphosphine et les mélanges de ceux-ci.

13. Procédé selon l'une quelconque des revendications 9 à 12, le mélange obtenu dans l'étape e) et/ou dans l'étape g) et/ou dans l'étape iii) étant chauffé à une température dans une plage de 180°C jusqu'à 320°C, préférablement dans une plage de 240°C jusqu'à 310°C.

14. Utilisation d'un point quantique coeur-multi-enveloppe sans cadmium selon l'une quelconque des revendications 1 à 8 pour l'utilisation dans des OLED, des piles solaires, des moyens d'éclairage, des scintillateurs à rayons X, des collecteurs fluorescents, des transistors organiques à effet de champ, en tant que marqueur de fluorescence en bioanalytique ou en tant que caractéristique de sécurité luminescente.

15. Composant optoélectronique, présentant au moins un point quantique coeur-multi-enveloppe sans cadmium selon l'une quelconque des revendications 1 à 8.
